# EUROPEAN PATENT APPLICATION

(11) **EP 4 543 148 A1**
(43) Date of publication of application: **23.04.2025**
(21) Application number: 23868399.9
(22) Date of filing: 17.08.2023
(51) Int. Cl.: H05K 1/02, H05K 1/14, H05K 9/00, H05K 7/20

(54) **PCB ASSEMBLY COMPRISING THERMAL MODULE**

(30) Priority: 19.09.2022 KR 20220117619; 11.10.2022 KR 20220129591
(71) Applicant: Samsung Electronics Co., Ltd., Suwon-si, Gyeonggi-do 16677 (KR)
(72) Inventor: CHUNG, Haein, Suwon-si Gyeonggi-do 16677 (KR); KANG, Junghan, Suwon-si Gyeonggi-do 16677 (KR); RHEE, Bongjae, Suwon-si Gyeonggi-do 16677 (KR); LIM, Jonghyun, Suwon-si Gyeonggi-do 16677 (KR)
(74) Representative: HGF
(86) International application number: PCT/KR2023/012148
(87) International publication number: WO 2024/063341

(57) **Abstract**

A PCB assembly according to one embodiment comprise: a first circuit board; an electronic component provided on the first circuit board: a second circuit board connected to the first circuit board: a thermal module configured to absorb heat from the electronic component; and a pressurizing structure configured to apply a pre-load to the thermal module in a direction toward the electronic component, wherein the pressurizing structure may be supported on the first circuit board or an external structure, while separated from the second circuit board.

## Description

### BACKGROUND

### 1. Field

The disclosure relates to a printed circuit board (PCB) assembly comprising a thermal module.

### 2. Description of Related Art

With the development of technology, hardware performance of an electronic device has increased and the size of the electronic device has miniaturized. For example, to a component such as a central processing unit (CPU) or an application processor (AP) of an electronic device, a product in the unit of hundreds of Mhz was applied in the past. However, recently, a product in the unit of Ghz has been applied and launched.

A printed circuit board (PCB) assembly including a high-performance electronic component may require a high-performance circuit board for driving an electronic component, and thus, the cost of a component may increase.

That is, a high-performance electronic component may accelerate a heating problem and as the PCB assembly or an electronic device including the PCB assembly may be overheated and thus, a portion of the performance may be degraded or an internal component may be damaged.

However, the aforementioned description shall not be interpreted as a prior art acknowledged by an applicant with respect to the description herein and shall be interpreted as only a related art to the invention described herein.

### SUMMARY

Provided is a printed circuit board (PCB) assembly that may be formed by integrating a high-specification circuit board on which an electronic component, such as a central processing unit (CPU), a memory, or a graphics element is disposed with a relatively low-specification circuit board. The provided PCB assembly integrating different circuit boards may secure cost competitiveness and may be advantageous to miniaturization of the PCB assembly.

Provided is a PCB assembly including a thermal module for controlling a temperature of an electronic component.

The technical goals to be achieved through embodiments of the present disclosure are not limited to those described above, and other technical goals not mentioned above are clearly understood by one of ordinary skill in the art from the following description.

Additional aspects will be set forth in part in the description which follows and, in part, will be apparent from the description, or may be learned by practice of the presented embodiments.

According to an aspect of the disclosure, a PCB assembly may include a first circuit board, an electronic component provided on the first circuit board, a second circuit board connected to the first circuit board, a thermal module configured to absorb heat from the electronic component, and a pressurizing structure configured to apply a pre-load to the thermal module in a direction toward the electronic component, where the pressurizing structure may be separated from the second circuit board and may be supported by the first circuit board or an external structure.

According to an aspect of the disclosure, a PCB assembly may include a first circuit board, an electronic component provided on the first circuit board, a thermal module configured to absorb heat from the electronic component and a pressurizing structure provided between the thermal module and the electronic component and configured to apply a pre-load to the thermal module, where the pressurizing structure may be separated from the second circuit board and may be supported by an external structure by penetrating the first circuit board.

According to an aspect of the disclosure, a PCB assembly may include a first circuit board, an electronic component provided on the first circuit board, a second circuit board connected to the first circuit board, a thermal module configured to absorb heat from the electronic component, a bracket connected to the thermal module and secured to the first circuit board, a first securing member provided on the first circuit board and supported by the first circuit board, a second securing member provided on the bracket and securing the bracket to the first securing member, and a pressurizing structure provided between the bracket and the second securing member and configured to apply a pre-load to the thermal module in a direction toward the electronic component, where the pressurizing structure may be separated from the second circuit board and may be supported by the first circuit board.

### BRIEF DESCRIPTION OF DRAWINGS

The above and other aspects, features, and advantages of certain embodiments of the present disclosure will be more apparent from the following description taken in conjunction with the accompanying drawings, in which:
FIG. 1 is a diagram of an electronic device in a network environment according to an embodiment;
FIG. 2A is a front perspective view of an electronic device according to an embodiment;
FIG. 2B is a rear perspective view of the electronic device according to an embodiment;
FIG. 2C is an exploded perspective view of the electronic device according to an embodiment;
FIG. 3 is a cross-sectional view of a printed circuit board (PCB) assembly according to an embodiment;
FIG. 4 is a cross-sectional view of a PCB assembly according to an embodiment;
FIG. 5 is a cross-sectional view of a PCB assembly according to an embodiment;
FIG. 6 is a cross-sectional view of a PCB assembly according to an embodiment;
FIG. 7A is a perspective view of an electronic device according to an embodiment;
FIG. 7B is an exploded perspective view of a first housing of the electronic device according to an embodiment;
FIG. 8A is a cross-sectional view of a PCB assembly in a disassembled state according to an embodiment;
FIG. 8B is a cross-sectional view of the PCB assembly according to an embodiment;
FIG. 9 is a cross-sectional view of a PCB assembly according to an embodiment;
FIG. 10 is a cross-sectional view of a PCB assembly according to an embodiment;
FIG. 11 is a cross-sectional view of a PCB assembly according to an embodiment; and
FIG. 12 is a cross-sectional view of a PCB assembly according to an embodiment.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms. It is to be understood that singular forms include plural referents unless the context clearly dictates otherwise. The terms including technical or scientific terms used in the disclosure may have the same meanings as generally understood by those skilled in the art.

It should be appreciated that various example embodiments of the present disclosure and the terms used therein are not intended to limit the technical features set forth herein to particular example embodiments and include various changes, equivalents, or replacements for a corresponding example embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

As used in connection with various example embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various example embodiments as set forth herein may be implemented as software (e.g., the processor 120) including one or more instructions that are stored in a storage medium (e.g., an internal memory 136 or an external memory 138) that is readable by a machine (e.g., the electronic device). For example, a processor of the machine (e.g., an electronic device) may invoke at least one of the one or more instructions stored in the storage medium and execute it. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Here, the term "non-transitory" simply indicates that the storage medium is a tangible device, and does not include a signal (e.g., an electromagnetic wave), but this term does not differentiate between where data is semi-permanently stored in the storage medium and where the data is temporarily stored in the storage medium.

According to an example embodiment, a method according to various example embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components may be omitted, or one or more other components may be added. Alternatively or additionally, a plurality of components (e.g., modules or programs) may be integrated into a single component. In such a case, according to various example embodiments, the integrated component may still perform one or more functions of each of the plurality of components in the same or similar manner as they are performed by a corresponding one of the plurality of components before the integration. According to various example embodiments, operations performed by the module, the program, or another component may be carried out sequentially, in parallel, repeatedly, or heuristically, or one or more of the operations may be executed in a different order or omitted, or one or more other operations may be added.

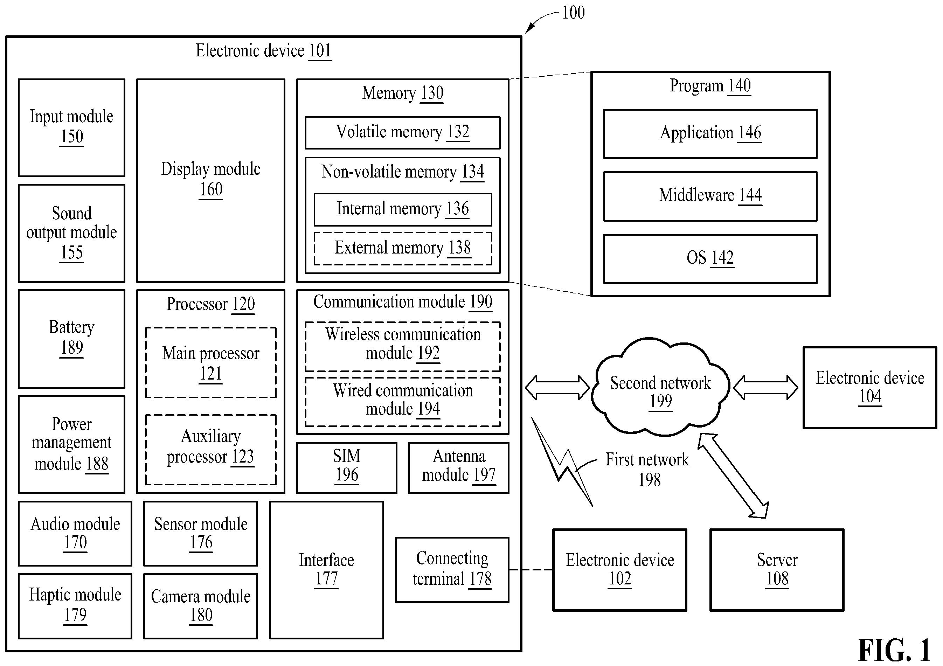

FIG. 1 is a block diagram illustrating an electronic device 101 in a network environment 100 according to an embodiment. Referring to FIG. 1, the electronic device 101 in the network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to one embodiment, the electronic device 101 may communicate with the electronic device 104 via the server 108. According to one embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the above components may be omitted from the electronic device 101, or one or more other components may be added in the electronic device 101. In some embodiments, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120, and may perform various data processing or computation. According to one embodiment, as at least a part of data processing or computation, the processor 120 may store a command or data received from another component (e.g., the sensor module 176 or the communication module 190) in a volatile memory 132, process the command or the data stored in the volatile memory 132, and store resulting data in a nonvolatile memory 134. According to one embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is in an active state (e.g., executing an application). According to one embodiment, the auxiliary processor 123 (e.g., an ISP or a CP) may be implemented as a portion of another component (e.g., the camera module 180 or the communication module 190) that is functionally related to the auxiliary processor 123. According to one embodiment, the auxiliary processor 123 (e.g., an NPU) may include a hardware structure specified for artificial intelligence (AI) model processing. An AI model may be generated by machine learning. Such learning may be performed by, for example, the electronic device 101 in which artificial intelligence is performed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The AI model may additionally or alternatively include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the nonvolatile memory 134.

The program 140 may be stored as software in the memory 130 and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing record. The receiver may be used to receive an incoming call. According to one embodiment, the receiver may be implemented separately from the speaker or as a part of the speaker.

The display module 160 may visually provide information to the outside (e.g., a user) of the electronic device 101. The display module 160 may include, for example, a control circuit for controlling a display, a hologram device, or a projector and control circuitry to control a corresponding one of the display, the hologram device, and the projector. According to one embodiment, the display module 160 may include a touch sensor adapted to sense a touch, or a pressure sensor adapted to measure an intensity of a force incurred by the touch.

The audio module 170 may convert a sound into an electric signal or vice versa. According to one embodiment, the audio module 170 may obtain the sound via the input module 150 or output the sound via the sound output module 155 or an external electronic device (e.g., an electronic device 102 such as a speaker or a headphone) directly or wirelessly connected to the electronic device 101.

The sensor module 176 may detect an operational state (e.g., power or temperature) of the electronic device 101 or an environmental state (e.g., a state of a user) external to the electronic device 101, and generate an electrical signal or data value corresponding to the detected state. According to one embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an example embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to one embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or an electrical stimulus which may be recognized by a user via his or her tactile sensation or kinesthetic sensation. According to one embodiment, the haptic module 179 may include, for example, a motor, a piezoelectric element, or an electric stimulator.

The camera module 180 may capture a still image and moving images. According to one embodiment, the camera module 180 may include one or more lenses, image sensors, ISPs, or flashes.

The power management module 188 may manage power supplied to the electronic device 101. According to one embodiment, the power management module 188 may be implemented as, for example, at least a part of a power management integrated circuit (PMIC).

The battery 189 may supply power to at least one component of the electronic device 101. According to one embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently of the processor 120 (e.g., an AP) and that support a direct (e.g., wired) communication or a wireless communication. According to one embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5^{th} generation (5G) network, a next-generation communication network, the Internet, or a computer network (e.g., a LAN or a wide area network (WAN))). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a 4G network, and a next-generation communication technology, e.g., a new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an example embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to one embodiment, the antenna module 197 may include an antenna including a radiating element including a conductive material or a conductive pattern formed in or on a substrate (e.g., a printed circuit board (PCB)). According to one embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to one embodiment, another component (e.g., a radio frequency integrated circuit (RFIC)) other than the radiating element may be additionally formed as a part of the antenna module 197.

According to one embodiment, the antenna module 197 may form a mmWave antenna module. According to one embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to one embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to one embodiment, all or some of operations to be executed by the electronic device 101 may be executed at one or more of the external electronic devices 102, 104, and 108. For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and may transfer an outcome of the performing to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra low-latency services using, e.g., distributed computing or mobile edge computing. **In** one embodiment, the external electronic device 104 may include an Internet-of-things (IoT) device. The server 108 may be an intelligent server using machine learning and/or a neural network. According to one embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the present disclosure, the electronic device is not limited to those described above.

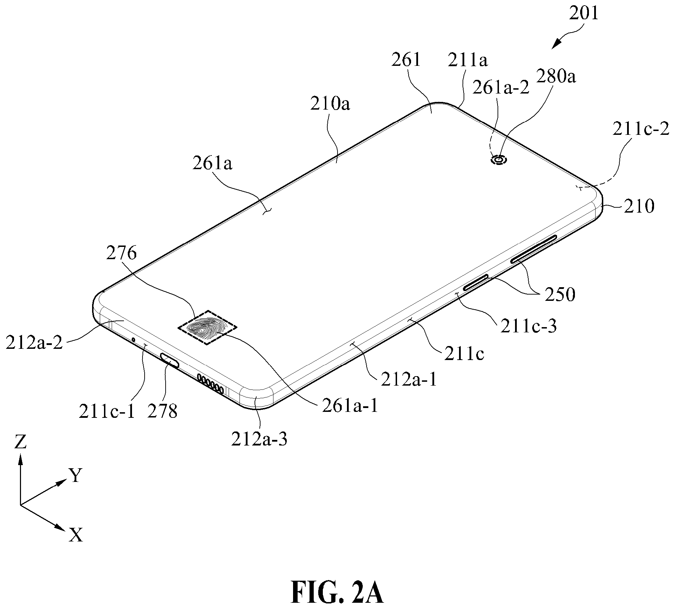

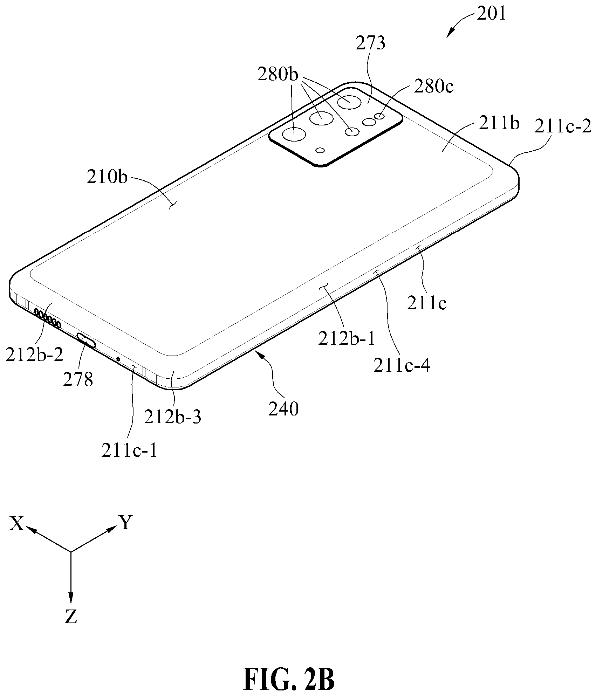

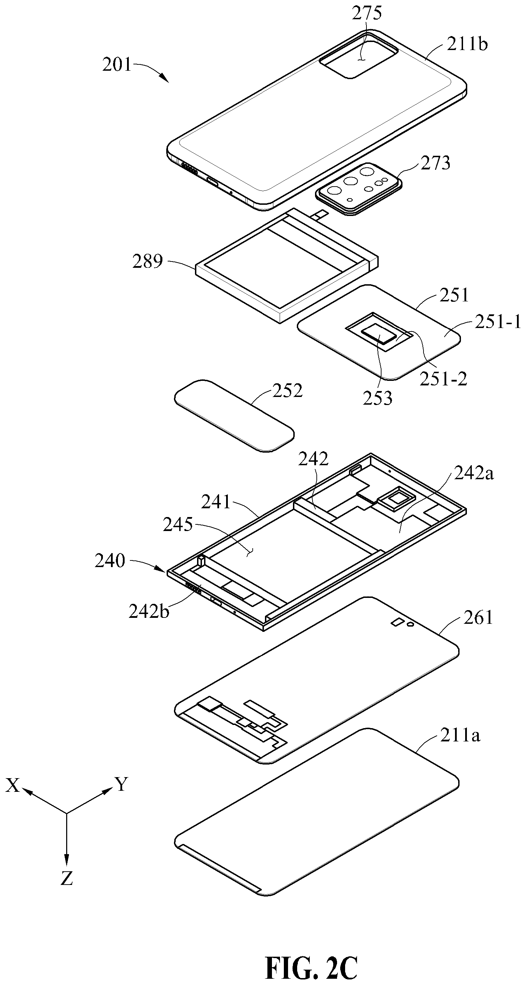

FIG. 2A is a front perspective view of an electronic device 201 according to an embodiment. FIG. 2B is a rear perspective view of the electronic device 201 according to an embodiment. FIG. 2C is an exploded perspective view of the electronic device 201 according to an embodiment.

Referring to FIGS. 2A to 2C, the electronic device 201 (e.g., the electronic device 101 of FIG. 1) in an embodiment may include a housing 210 forming an exterior and accommodating a component therein. The housing 210 may include a front surface 210a, a rear surface 210b, and a side surface 211c enclosing an inner space between the front surface 210a and the rear surface 210b. The housing 210 may include a plurality of side surfaces 211c extending from the front surface 210a to the rear surface 210b and the plurality of side surfaces 211c may include a lower side surface 211c-1, an upper side surface 211c-2, a right side surface 211c-3, and a left side surface 211c-4.

In an embodiment, the front surface 210a may be formed by a front plate 211a of which at least a portion is substantially transparent. For example, the front plate 211a may include a polymer plate or a glass plate including at least one coating layer. In an embodiment, the rear surface 210b may be formed by a rear plate 211b that is substantially opaque.

For example, the rear plate 211b may be formed of coated or tinted glass, ceramic, polymer, metal (e.g., aluminum, stainless steel, or magnesium), or a combination thereof. The side surface 211c may be coupled to the front plate 211a and the rear plate 211b and may be formed by a side member 240 including metal and/or polymer. In an embodiment, the rear plate 211b and the side member 240 may be integrally and seamlessly formed. In an embodiment, the rear plate 211b and the side member 240 may be formed of substantially the same material (e.g., aluminum).

In an embodiment, the front plate 211a may include a plurality of first periphery areas 212a-1 that are rounded in a direction from at least one area of the front surface 210a toward the rear plate 211b and extend in one direction (e.g., a + or -X-axis direction), a plurality of second periphery areas 212a-2 that are rounded in the direction from at least one area of the front surface 210a toward the rear plate 211b and extend in the other direction (e.g., a + or -Y-axis direction), and a plurality of third periphery areas 212a-3 that are rounded in the direction from at least one area of the front surface 210a toward the rear plate 211b and disposed between the plurality of first periphery areas 212a-1 and the plurality of second periphery areas 212a-2.

In an embodiment, the rear plate 211b may include a plurality of fourth periphery areas 212b-1 that are rounded in a direction from at least one area of the rear surface 210b toward the front plate 211a and extend in one direction (e.g., a + or -X-axis direction), a plurality of fifth periphery areas 212b-2 that are rounded in the direction from at least one area of the rear surface 210b toward the front plate 211a and extend in the other direction (e.g., a + or -Y-axis direction), and a plurality of sixth periphery areas 212b-3 that are rounded in the direction from at least one area of the rear surface 210b toward the front plate 211a and disposed between the plurality of fourth periphery areas 212b-1 and the plurality of fifth periphery areas 212b-2.

In an embodiment, the side member 240 may surround at least a portion of the inner space between the front surface 210a and the rear surface 210b. The side member 240 may include a first support structure 241 disposed on at least a portion of the side surface 211c and a second support structure 242 connected to the first support structure 241 to form a space for disposing the components of the electronic device 201.

In an embodiment, the first support structure 241 may connect the periphery of the front plate 211a and the periphery of the rear plate 211b and surround the space between the first plate 211a and the second plate 211b, thereby forming the side surface 211c of the housing 210. In an embodiment, the second support structure 242 may be disposed inside (or in a body portion) of the electronic device 201. The second support structure 242 may be integrally formed with the first support structure 241 or may be formed separately from the first support structure 241 and connected to the first support structure 241. In an embodiment, the first support structure 241 and/or the second support structure 242 may be a component of the housing 210.

In an embodiment, at least one PCB assembly 251 or 252 may be disposed in the second support structure 242. The second support structure 242 may be, for example, connected to a ground of the at least one PCB assembly 251 or 252.

**In** an embodiment, a display 261 may be disposed on a first surface (e.g., a lower surface (a surface in the +Z-axis direction) of FIG. 2C) of the second support structure 242 and the rear plate 211b may be disposed on a second surface (e.g., an upper surface (a surface in the -Z-axis direction) of FIG. 2C) of the second support structure 242.

**In** an embodiment, at least a portion of the side member 240 may be formed of a conductive material. For example, the first support structure 241 may be formed of a metal and/or conductive polymer material. **In** an embodiment, the second support structure 242 may be formed of a metal and/or conductive polymer material, like the first support structure 241.

**In** an embodiment, the rear plate 211b of the housing 210 may include a camera hole 275 to receive a second camera module 280b and a flash 280c and the housing 210 may include a camera decoration 273 for protecting the second camera module 280b and the flash 280c. The camera decoration 273 may be coupled to the rear plate 211b and may be visually exposed to the outside of the housing 210 by being disposed on the camera hole 275.

**In** an embodiment, the electronic device 201 may include the display 261 (e.g., the display module 160 of FIG. 1). **In** an embodiment, the display 261 may be disposed on the front surface 210a. **In** an embodiment, the display 261 may be exposed through at least a portion (e.g., the plurality of first periphery areas 212a-1, the plurality of second periphery areas 212a-2, and the plurality of third periphery areas 212a-3) of the front plate 211a. **In** an embodiment, the display 261 may have a shape that is substantially the same as the shape of an outer edge of the front plate 211a.

In an embodiment, the edge of the display 261 may substantially coincide with an outer edge of the front plate 211a. The display 261 in an embodiment may include a touch sensing circuit, a pressure sensor for sensing an intensity (pressure) of a touch, and/or a digitizer for detecting a magnetic-type stylus pen.

**In** an embodiment, the display 261 may include a screen display area 261a that is visually exposed and displays content through a pixel or a plurality of cells. **In an** embodiment, the screen display area 261a may include a sensing area 261a-1 and/or a camera area 261a-2. **In** this case, the sensing area 261a-1 may overlap with at least a portion of the screen display area 261a. The sensing area 261a-1 may allow transmission of an input signal related to a sensor module 276 (e.g., the sensor module 176 of FIG. 1). The sensing area 261a-1 may display content, like the screen display area 261a that does not overlap the sensing area 261a-1.

For example, the sensing area 261a-1 may display the content while the sensor module 276 is not operating. The camera area 261a-2 may overlap at least one area of the screen display area 261a. The camera area 261a-2 may allow transmission of an optical signal related to camera modules 280a and 280b (e.g., the camera module 180 of FIG. 1). The camera area 261a-2 may display content, like the screen display area 261a that does not overlap the camera area 261a-2. For example, the camera area 261a-2 may display the content while the camera module 280a or 280b is not operating.

**In** an embodiment, the electronic device 201 may include the sensor module 276. The sensor module 276 may sense a signal applied to the electronic device 201. The sensor module 276 may be positioned, for example, on the front surface 210a of the electronic device 201. The sensor module 276 may form the sensing area 261a-1 in at least a portion of the screen display area 261a. The sensor module 276 may receive an input signal transmitted through the sensing area 261a-1 and generate an electrical signal based on the received input signal. For example, the input signal may have a designated physical quantity (e.g., heat, light, temperature, sound, pressure, or ultrasound). As another example, the input signal may include a signal related to biometric information (e.g., a fingerprint, a voice, and the like) of a user.

In an embodiment, the electronic device 201 may include the camera modules 280a and 280b (e.g., the camera module 180 of FIG. 1). In an embodiment, the camera modules 280a and 280b may include the first camera module 280a and the second camera module 280b and may further include a flash 280c in an embodiment.

In an embodiment, the first camera module 280a may be disposed to be exposed to the outside through the front surface 210a of the housing 210 and the second camera module 280b and the flash 280c may be disposed to be exposed through the rear surface 210b of the housing 210. In an embodiment, at least a portion of the first camera module 280a may be disposed in the housing 210 so as to be covered through the display 261. In an embodiment, the first camera module 280a may receive an optical signal transmitted through the camera area 261a-2. In an embodiment, the second camera module 280b may include a plurality of cameras (e.g., dual cameras, triple cameras, or quad cameras). In an embodiment, the flash 280c may include a light-emitting diode or a xenon lamp.

The electronic device 201 may include an input module 250 (e.g., the input module 150 of FIG. 1). The input module 250 may receive a manipulation signal of a user. The input module 250 may include, for example, at least one key input device disposed to be exposed on the side surface 211c of the housing 210.

In an embodiment, the electronic device 201 may include a connecting terminal 278 (e.g., the connecting terminal 178 of FIG. 1). In an embodiment, a connecting terminal 278 may be disposed on the outer circumferential surface of the housing 210 and for example, may be disposed on a lower side surface 211c-1 of the electronic device 201 as illustrated in FIG. 2A. Specifically, when the electronic device 201 is viewed in a direction (e.g., the +Y-axis direction of FIG. 2A), the connecting terminal 278 may be disposed on the central portion of the lower side surface 211c-1.

As illustrated in FIGS. 2A and 2B, the connecting terminal 278 may be disposed on the side surface 211c of the housing 210 that forms the exterior of the electronic device 201. However, in actual implementation, the example is not limited thereto and at least a portion of the connecting terminal 278 may be disposed on the front surface 210a or the rear surface 210b of the housing 210 or may be disposed inside the housing 210. For example, although not illustrated in the drawings, the housing 210 in an embodiment may include a cover for replacing a battery 289.

In an embodiment, the electronic device 201 may include the battery 289 (e.g., the battery 189 of FIG. 1) and at least one PCB assembly 251 or 252 including one or more PCBs.

In an embodiment, the electronic device 201 may include a plurality of PCB assemblies 251 and 252 and for example, the plurality of PCB assemblies 251 and 252 may be configured in two PCB assemblies spaced apart from each other. For example, the plurality of PCB assemblies 251 and 252 may include the first PCB assembly 251 and the second PCB assembly 252.

The first PCB assembly 251 in an embodiment may be a main board of the electronic device 201 that is accommodated in a first board slot 242a of the second support structure 242 and the second PCB assembly 252 may be a sub-board of the electronic device 201 that is accommodated in a second board slot 242b of the second support structure 242.

In an embodiment, the battery 289 may be accommodated in a battery slot 245 of the second support structure 242 formed between the first board slot 242a and the second board slot 242b.

In an embodiment, in the PCB assemblies 251 and 252, the first PCB assembly 251 illustrated in FIG. 2C, for example, may be formed by integrating different PCBs and the different PCBs may include a first circuit board 251-1 and a second circuit board 251-2.

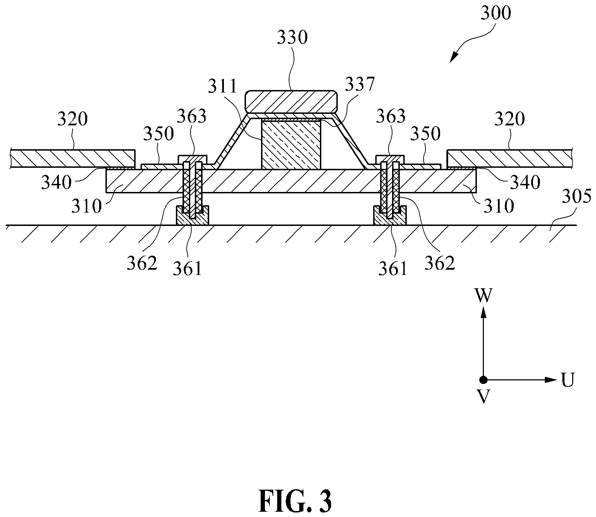

In an embodiment, the second circuit board 251-2 may include at least one electronic component 253 and may include a different structure (e.g., a thermal module 330 or a pressurizing structure 350 of FIG. 3) associated therewith.

In an embodiment, the electronic component 253 may include various circuits or some components for driving or controlling the electronic device 201. For example, the electronic component 253 may be an integrated circuit. The electronic component 253 may generate heat due to operation and may need to be cooled.

In an embodiment, the electronic component 253 may be a CPU (e.g., the processor 120 or the main processor 121 of FIG. 1) or an AP, which is an element for performing key operations of the electronic device 201.

In an embodiment, the electronic component 253 may be a wireless communication circuit (e.g., the wireless communication module 192 of FIG. 1). The wireless communication circuit may communicate with, for example, an external device (e.g., the electronic device 104 of FIG. 1). The electronic device 201 may include an antenna (e.g., the antenna module 197 of FIG. 1), and the wireless communication circuit may be electrically connected to an antenna structure. The wireless communication circuit may generate a signal to be transmitted through the antenna structure or detect a signal received through the antenna structure. For example, the PCB assembly 251 or 252 may include ground and the ground of the PCB assembly 251 or 252 may function as ground of the antenna structure implemented using the wireless communication circuit. However, the example is not limited thereto and the electronic component 253 may be a graphics component (e.g., a portion of the display module 160 of FIG. 1).

Hereinafter, based on the description of the electronic device 201, a configuration and a structure of a PCB assembly 300 in an embodiment are described. Hereinafter, to describe the electronic device 201, a duplicated description with the electronic device 201 is omitted and a portion of the configuration or a structure may be replaced, added, or omitted within a scope that one of ordinary skill in the art may easily understand.

FIG. 3 is a cross-sectional view of a PCB assembly 300 according to an embodiment.

Referring to FIG. 3, the PCB assembly 300 (e.g., the PCB assembly 251 of FIG. 2C) may include a first circuit board 310 (e.g., the first circuit board 251-1 of FIG. 2C), a second circuit board 320 (e.g., the second circuit board 251-2 of FIG. 2C), a thermal module 330, and a pressurizing structure 350.

In an embodiment, the PCB assembly 300 may be the PCB assembly 300 including different PCBs where the first circuit board 310 is coupled or connected to the second circuit board 320. The first circuit board 310 and the second circuit board 320 may be separate circuit boards and may be connected to each other through a connecting member 340, such as a soldering member.

In an embodiment, the connecting member 340 may physically bond the first circuit board 310 to the second circuit board 320 or may electrically and communicably connect the first circuit board 310 to the second circuit board 320.

In an embodiment, the PCB assembly 300 may include an electronic component 311 (e.g., the electronic component 253 of FIG. 2C). However, the electronic component 311 described herein is only one of various components included in the PCB assembly 300. In actual implementation, the PCB assembly 300 may include one or more electronic components of various types, structures, and arrangements.

For example, the electronic component 311 may refer to a component, which requires heat protection or temperature control by the thermal module 330, of various components included in the PCB assembly 300. The electronic component 311 may be a CPU or an AP configured to perform key operations, a CP, a wireless communication circuit, or a graphics element.

In an embodiment, the electronic component 311 may be disposed on the first circuit board 310. For example, the first circuit board 310 may be a core circuit board or a main circuit board. The first circuit board 310 may be a relatively high-specification or highly integrated circuit board compared to the second circuit board 320.

In an embodiment, the second circuit board 320 may be connected to the first circuit board 310. For example, the second circuit board 320 may be a sub-circuit board or an auxiliary circuit board. The second circuit board 320 may be a relatively low-specification or less integrated circuit board compared to the first circuit board 310.

In an embodiment, the first circuit board 310 may be fabricated from a relatively low-less material or a low-permittivity material compared to the second circuit board 320. Easiness and economic feasibility in fabrication of the PCB assembly 300 may be secured by including the first circuit board 310, in which the electronic component 311 is disposed, and the second circuit board 320 connected to the first circuit board 310 in the PCB assembly 300.

In an embodiment, the thermal module 330 may absorb heat from the electronic component 311. For example, the thermal module 330 may be a cooling module or a heat protection module. The thermal module 330 may absorb external heat or heat generated due to operation of the electronic component 311. Alternatively, the thermal module 330 may control the temperature of the electronic component 311 or the PCB assembly 300 to prevent the electronic component 311 from overheating.

For example, the thermal module 330 may be a type of a heat spreading member (e.g., a heat pipe, a vapor chamber, a graphite sheet, a Cu plate, a Cu sheet, or any combination thereof) and may rapidly spread heat generated by a component to the outside of the component. Alternatively, the thermal module 330 may be a fan that directly reduces heat of the component or a water cooling member including a thermoelectric element.

In an embodiment, the pressurizing structure 350 may apply a pre-load to the thermal module 330 and/or the electronic component 311 to reduce or minimize the contact heat resistance between the thermal module 330 and the electronic component 311. For example, the pressurizing structure 350 may apply a pre-load to the thermal module 330 in a direction toward the electronic component 311. The thermal module 330 and the electronic component 311 may closely contact each other through the pressurizing structure 350.

In an embodiment, a thermal interface material (TIM) 337 may be disposed between the pressurizing structure 350 and the electronic component 311. The TIM 337 may include a thermal conductive material.

In an embodiment, the TIM 337 may be applied and cured in a cream or paste state between the pressurizing structure 350 and the electronic component 311. However, the example is not limited thereto.

In an embodiment, the TIM 337 may improve thermal conductivity between the pressurizing structure 350 and the electronic component 311. However, the TIM 337 may be omitted and in this case, the pressurizing structure 350 and the electronic component 311 may be directly contact each other and thermally connect to each other.

In an embodiment, the pressurizing structure 350 may be a plate-shaped elastic body. A first surface (e.g., a surface in the +W direction) of the pressurizing structure 350 may be connected to the thermal module 330 and a second surface (e.g., a surface in the -W direction) opposite to the first surface may be connected to the electronic component 311. The TIM 337 may be disposed between the pressurizing structure 350 and the electronic component 311, and at least a portion of heat generated by the electronic component 311 may move to the pressurizing structure 350 through the TIM 337.

In an embodiment, the pressurizing structure 350 may apply stress to the first circuit board 310 or the second circuit board 320 based on the shape, arrangement, and/or structure of a plurality of securing members 361, 362, and 363. For example, when the pressurizing structure 350 is supported by the second circuit board 320, the second circuit board 320 may receive a reaction force corresponding to the pre-load.

In an embodiment, the stress transferred to the first circuit board 310 or the second circuit board 320 may affect the connecting member 340. The stress may cause at least partial damage or cracks of the connecting member 340. When the connecting member 340 is damaged, a poor connection or disconnection between the first circuit board 310 and the second circuit board 320 may occur.

In an embodiment, when the pressurizing structure 350 is not fixed to the second circuit board 320 (e.g., separated from, spaced apart from, not attached to, not adhered to, removed from, in an unfixed state with respect to, etc.), the pressurizing structure 350 may be supported by the first circuit board 310 or an external structure 305. Alternatively, the pressurizing structure 350 may not be fixed to or supported by the second circuit board 320. Alternatively, the pressurizing structure 350 may not contact the second circuit board 320. As the pressurizing structure 350 is fixed to the first circuit board 310 or the external structure 305 and not the second circuit board 320, the pressurizing structure 350 may suppress or minimize stress transferred to the connecting member 340.

For example, the pressurizing structure 350 may be supported by the external structure 305 by penetrating the first circuit board 310. The external structure 305 may be an external support body or a component of the PCB assembly 300. For example, the external structure 305 may be a separate support component included in the PCB assembly 300 or an external housing (e.g., the first board slot 242a or the second board slot 242b of FIG. 2C) that is different from the PCB assembly 300.

Hereinafter, a structure for suppressing or minimizing stress that occurs in the connecting member 340 of the PCB assembly 300 is described through various embodiments. However, this is an example and at least a portion of the structure and arrangement may be implemented with various design modifications within a scope that one of ordinary skill in the art may easily modify and the scope of the present disclosure is not limited to the following descriptions and drawings.

In an embodiment, the PCB assembly 300 may include a plurality of securing members 361, 362, and 363. For example, the plurality of securing members 361, 362, and 363 may include a first securing member 361, a second securing member 362, and a third securing member 363.

In an embodiment, the first securing member 361 may be a support structure supported by the external structure 305. For example, the first securing member 361 may be an internal thread, a nut, or a support body that is secured to the external structure 305 and has a fitment structure.

In an embodiment, the second securing member 362 may be disposed on the first circuit board 310. The second securing member 362 may penetrate the first circuit board 310, may be inserted into the first circuit board 310, or may be secured to the first circuit board 310. The second securing member 362 may self-clinch to the first circuit board 310 and for example, the second securing member 362 may be a clinching nut, an insert nut, or a swage nut.

In an embodiment, the second securing member 362 may be secure to the first securing member 361. As the second securing member 362 is secured to the first securing member 361, the second securing member 362 may secure the first circuit board 310 to the first securing member 361 and the external structure 305.

In an embodiment, the third securing member 363 may have a structure that is able to be inserted into or secured to the first securing member 361 and/or the second securing member 362. For example, the third securing member 363 may be an external thread or a bolt. Without being limited thereto, the third securing member 363 may be a structure in the shape of a nail, a cone, or a pillar having a circular or polygonal cross-section.

In an embodiment, the third securing member 363 may penetrate the pressurizing structure 350 and the second securing member 362. For example, a head of the third securing member 363 may contact a first surface of the pressurizing structure 350 and a shaft, which extends from the head, of the third securing member 363 may penetrate from the first surface of the pressurizing structure 350 to a second surface of the pressurizing structure 350. Without being limited thereto, at least a portion of the third securing member 363 may be secured or connected to the pressurizing structure 350 and may be integrally formed therewith as one.

In an embodiment, a penetrating hole may be formed in the second securing member 362 and the third securing member 363 may be secured to the first securing member 361 by penetrating the second securing member 362. As the third securing member 363 is secured to the first securing member 361, the third securing member 363 may secure the pressurizing structure 350 to the first securing member 361 and the external structure 305.

In an embodiment, a plurality of securing members 361, 362, and 363 may not be secured to or supported by the second circuit board 320 and may be secured to or supported by the first circuit board 310 or the external structure 305. The pressurizing structure 350 may transfer a pre-load or a portion of a reaction force of the pre-load to the first circuit board 310 or the external structure 305 and may reduce or minimize a force transferred to the second circuit board 320. The PCB assembly 300 including different circuit boards (e.g., the first circuit board 310 and the second circuit board 320) may provide improved durability by reducing or minimizing stress applied to the connecting member 340 through the plurality of securing members 361, 362, and 363.

In an embodiment, the PCB assembly 300 including the plurality of securing members 361, 362, and 363 may have relatively fewer required components for a securing member, the volume of the PCB assembly 300 may decrease, and/or the PCB assembly 300 may be relatively easily coupled.

In an embodiment, since the PCB assembly 300 including the plurality of securing members 361, 362, and 363 only requires a small amount of space for the second securing member 362 to penetrate the first circuit board 310, a circuit board may be relatively easily processed, miniaturization and space efficiency may be provided, and/or improved durability may be provided.

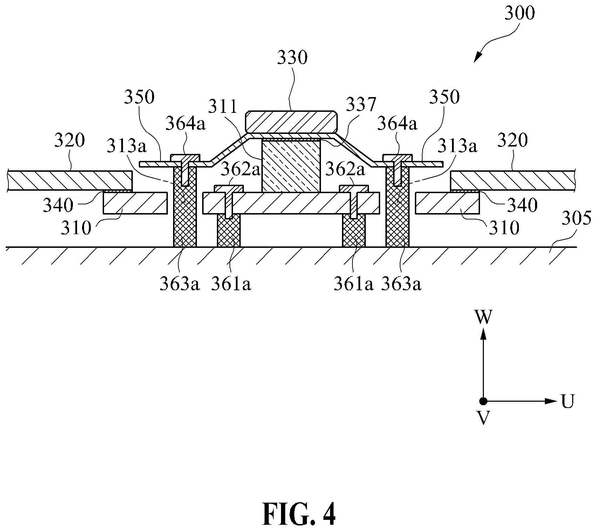

FIG. 4 is a cross-sectional view of a PCB assembly 300 according to an embodiment.

Referring to FIG. 4, the PCB assembly 300 in an embodiment may include a plurality of securing members 361a, 362a, 363a, and 364a. In some embodiments, the PCB assembly 300 may include at least a portion of the first securing member 361a, the second securing member 362a, the third securing member 363a, and the fourth securing member 364a.

In the description of FIG. 4, the structure and configuration of the PCB assembly 300 are described and repeated descriptions with PCB assemblies described above may be omitted. Furthermore, this is only an example and a portion of the configuration or a structure may be replaced, added, or omitted within a scope in which one of ordinary skill in the art may easily understand with reference to the following drawings and descriptions. In addition, at least one component or feature of embodiments described above may be coupled to the PCB assembly 300.

In an embodiment, the first securing member 361a and the third securing member 363a may each be a support structure that is also supported by the external structure 305. For example, the first securing member 361a and the third securing member 363a may be an internal thread, a nut, or a support body that is secured to the external structure 305 and has a fitment structure.

In an embodiment, in each of first securing member 361a and the third securing member 363a, a first surface may be secured to or supported by the external structure 305 and a second surface opposite to the first surface may have a pillar shape extending in a direction (e.g., the +W direction) away from the external structure 305.

In an embodiment, the second securing member 362a and the fourth securing member 364a may have a structure that is able to be inserted into or secured to the first securing member 361a and the third securing member 363a, respectively. For example, the second securing member 362a and the fourth securing member 364a may each be an external thread or a bolt. Without being limited thereto, the second securing member 362a and the fourth securing member 364a may be a structure in the shape of a nail, a cone, or a pillar having a circular or polygonal cross-section.

In an embodiment, the second securing member 362a may be disposed on the first circuit board 310. The second securing member 362a may penetrate the first circuit board 310, may be inserted into the first circuit board 310, may be secured to the first circuit board 310.

For example, a head of the second securing member 362a may contact a first surface of the first circuit board 310 and a shaft, which extends from the head, of the second securing member 362a may penetrate from the first surface of the first circuit board 310 to a second surface of the first circuit board 310.

In an embodiment, the second securing member 362a may be secured to the first securing member 361a. As the second securing member 362a is secured to the first securing member 361a, the second securing member 362a may secure the first circuit board 310 to the first securing member 361a and the external structure 305.

In an embodiment, the third securing member 363a may penetrate the first circuit board 310. For example, the first circuit board 310 may include at least one opening 313a that penetrates the first circuit board 310 in the vertical direction (e.g., a W-axis direction). The third securing member 363a may extend from the external structure 305 by penetrating the opening 313a and may penetrate the first circuit board 310.

In an embodiment, the fourth securing member 364a may be disposed on the pressurizing structure 350. The fourth securing member 364a may be disposed on the pressurizing structure 350, may be inserted into the pressurizing structure 350, or may be secured to the pressurizing structure 350.

For example, a head of the fourth securing member 364a may contact a first surface of the pressurizing structure 350 and a shaft, which extends from the head, of the fourth securing member 364a may penetrate from first surface of the pressurizing structure 350 to a second surface of the pressurizing structure 350. Without being limited thereto, at least a portion of the fourth securing member 364a may be secured or connected to the pressurizing structure 350 and may be integrally formed therewith as one.

In an embodiment, the fourth securing member 364a may be secured to the third securing member 363a. As the fourth securing member 364a is secured to the third securing member 363a, the fourth securing member 364a may secure the pressurizing structure 350 to the third securing member 363a and the external structure 305.

In an embodiment, a plurality of securing members 361a, 362a, 363a, and 364a may not be secured to or supported by the second circuit board 320 and may be secured to or supported by the first circuit board 310 or the external structure 305. The pressurizing structure 350 may transfer a pre-load or a portion of a reaction force of the pre-load to the first circuit board 310 or the external structure 305 and may reduce or minimize a force transferred to the second circuit board 320. The PCB assembly 300 including different circuit boards (e.g., the first circuit board 310 and the second circuit board 320) may provide improved durability by reducing or minimizing stress applied to the connecting member 340 through the plurality of securing members 361a, 362a, 363a, and 364a.

In an embodiment, in the PCB assembly 300 including the plurality of securing members 361a, 362a, 363a, and 364a, some structures (e.g., the third securing member 363a and the fourth securing member 364a) for supporting or securing the pressurizing structure 350 and that are not fixed to (e.g., in an unfixed state with respect to, spaced apart from, separated from, etc.) the first circuit board 310 and the second circuit board 320 may be supported by the external structure 305.

In an embodiment, since stress by the pressurizing structure 350 is not transferred to the first circuit board 310, the second circuit board 320, and the connecting member 340, the PCB assembly 300 including the plurality of securing members 361a, 362a, 363a, and 364a may reduce the durability problem due to pre-load application of the pressurizing structure 350 and the intensity control of a pre-load of the pressurizing structure 350 may be less limited. The PCB assembly 300 including the plurality of securing members 361a, 362a, 363a, and 364a may allow relatively easy circuit board design, the pressurizing structure 350 may apply a greater pre-load to the thermal module 330 and/or the electronic component 311, and/or may provide improved durability of the PCB assembly 300.

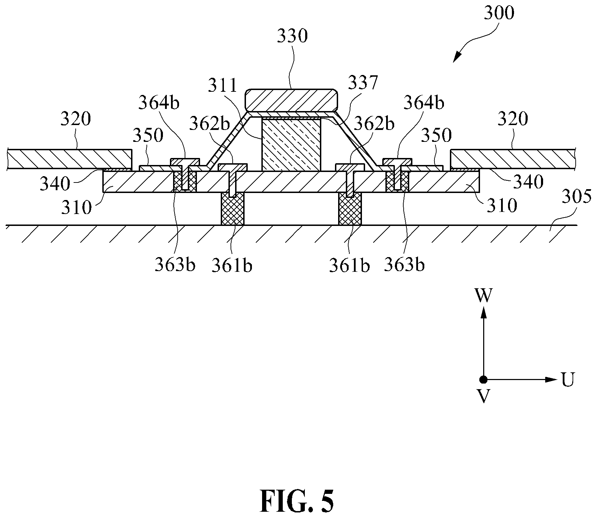

FIG. 5 is a cross-sectional view of a PCB assembly 300 according to an embodiment.

Referring to FIG. 5, the PCB assembly 300 in an embodiment may include a plurality of securing members 361b, 362b, 363b, and 364b. In some embodiments, the PCB assembly 300 may include at least a portion of the first securing member 361b, the second securing member 362b, the third securing member 363b, and the fourth securing member 364b.

In the description of FIG. 5, the structure and configuration of the PCB assembly 300 are described and repeated descriptions with PCB assemblies described above may be omitted. Furthermore, this is only an example and a portion of the configuration or a structure may be replaced, added, or omitted within a scope in which one of ordinary skill in the art may easily understand with reference to the following drawings and descriptions. In addition, at least one component or feature of embodiments described above may be coupled to the PCB assembly 300.

In an embodiment, the first securing member 361b may be a support structure supported by the external structure 305. For example, the first securing member 361b may be an internal thread, a nut, or a support body that is secured to the external structure 305 and has a fitment structure.

In an embodiment, in the first securing member 361b, a first surface may be secured to or supported by the external structure 305 and a second surface opposite to the first surface may have a pillar shape extending in a direction (e.g., the +W direction) away from the external structure 305.

In an embodiment, the second securing member 362b and the fourth securing member 364b may have a structure that is able to be inserted into or secured to the first securing member 361b and the third securing member 363b, respectively. For example, the second securing member 362b and the fourth securing member 364b may be an external thread or a bolt. Without being limited thereto, the second securing member 362b and the fourth securing member 364b may be a structure in the shape of a nail, a cone, or a pillar having a circular or polygonal cross-section.

In an embodiment, the second securing member 362b may be disposed on the first circuit board 310. The second securing member 362b may penetrate the first circuit board 310, may be inserted into the first circuit board 310, or may be secured to the first circuit board 310.

For example, a head of the second securing member 362b may contact a first surface of the first circuit board 310 and a shaft, which extends from the head, of the second securing member 362b may penetrate from the first surface of the first circuit board 310 to a second surface of the first circuit board 310.

In an embodiment, the second securing member 362b may be secured to the first securing member 361b. As the second securing member 362b is secured to the first securing member 361b, the second securing member 362b may secure the first circuit board 310 to the first securing member 361b and the external structure 305.

In an embodiment, the third securing member 363b may be disposed on the first circuit board 310. The third securing member 363b may be inserted into the first circuit board 310 and may be secured to the first circuit board 310. The third securing member 363b may self-clinch to the first circuit board 310 and for example, the third securing member 363b may be a clinching nut, an insert nut, or a swage nut.

In an embodiment, the fourth securing member 364b may be disposed on the pressurizing structure 350. The fourth securing member 364b may be disposed on the pressurizing structure 350, may be inserted into the pressurizing structure 350, or may be secured to the pressurizing structure 350.

For example, a head of the fourth securing member 364b may contact a first surface of the pressurizing structure 350 and a shaft, which extends from the head, of the fourth securing member 364b may penetrate from the first surface of the pressurizing structure 350 to a second surface of the pressurizing structure 350. Without being limited thereto, at least a portion of the fourth securing member 364b may be secured or connected to the pressurizing structure 350 and may be integrally formed therewith as one.

In an embodiment, the fourth securing member 364b may be secured to the third securing member 363b. As the fourth securing member 364b is secured to the third securing member 363b, the fourth securing member 364b may secure the pressurizing structure 350 to the third securing member 363b and the first circuit board 310. As the pressurizing structure 350 is secured to the first circuit board 310, the pressurizing structure 350 may be supported by the external structure 305 through the first securing member 361b and the second securing member 362b.

In an embodiment, a plurality of securing members 361b, 362b, 363b, and 364b may not be secured to or supported by the second circuit board 320 and may be secured to or supported by the first circuit board 310 or the external structure 305. The pressurizing structure 350 may transfer a pre-load or a portion of a reaction force of the pre-load to the first circuit board 310 or the external structure 305 and may reduce or minimize a force transferred to the second circuit board 320. The PCB assembly 300 including different circuit boards (e.g., the first circuit board 310 and the second circuit board 320) may provide improved durability by reducing or minimizing stress applied to the connecting member 340 through the plurality of securing members 361b, 362b, 363b, and 364b.

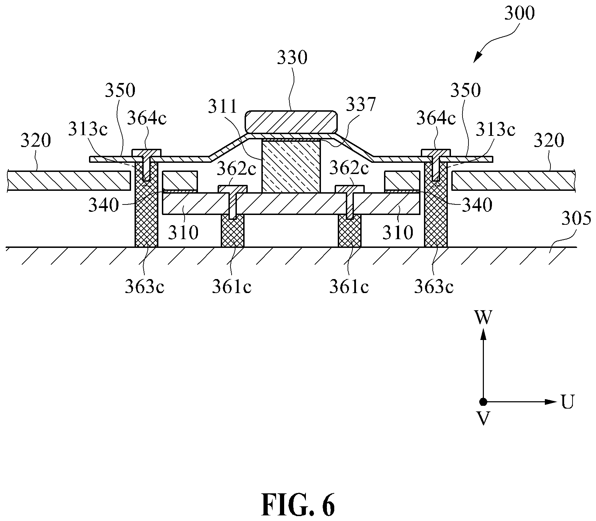

In an embodiment, since the third securing member 363b has a structure secured to the first circuit board 310, the PCB assembly 300 including the plurality of securing members 361b, 362b, 363b, and 364b may not require a separate opening (e.g., the opening 313a of FIG. 4 or an opening 313c of FIG. 6) of the first circuit board 310 or the second circuit board 320, a securing structure between the PCB assembly 300 and the external structure 305 may be relatively simplified, and/or the shape and structure of the plurality of securing members 361b, 362b, 363b, and 364b may be relatively simplified. The PCB assembly 300 including the plurality of securing members 361b, 362b, 363b, and 364b may provide relatively easy circuit board design and improved space efficiency.

FIG. 6 is a cross-sectional view of a PCB assembly 300 according to an embodiment.

Referring to FIG. 6, the PCB assembly 300 in an embodiment may include a plurality of securing members 361c, 362c, 363c, and 364c. The PCB assembly 300 may include at least a portion of the first securing member 361c, the second securing member 362c, the third securing member 363c, and the fourth securing member 364c.

In the description of FIG. 6, the structure and configuration of the PCB assembly 300 are described and repeated descriptions with PCB assemblies described above may be omitted. Furthermore, this is only an example and a portion of the configuration or a structure may be replaced, added, or omitted within a scope in which one of ordinary skill in the art may easily understand with reference to the following drawings and descriptions. In addition, at least one component or feature of embodiments described above may be coupled to the PCB assembly 300.

In an embodiment, the first securing member 361c and the third securing member 363c may each be a support structure supported by the external structure 305. For example, the first securing member 361c and the third securing member 363c may be an internal thread, a nut, or a support body that is secured to the external structure 305 and has a fitment structure.

In an embodiment, in each of first securing member 361c and the third securing member 363c, a first surface may be secured to or supported by the external structure 305 and a second surface opposite to the first surface may have a pillar shape extending in a direction (e.g., the +W direction) away from the external structure 305.

In an embodiment, the second securing member 362c and the fourth securing member 364c may have a structure that may be inserted into or secured to the first securing member 361c and the third securing member 363c, respectively. For example, the second securing member 362c and the fourth securing member 364c may be an external thread or a bolt. Without being limited thereto, the second securing member 362c and the fourth securing member 364c may be a structure in the shape of a nail, a cone, or a pillar having a circular or polygonal cross-section.

In an embodiment, the second securing member 362c may be disposed on the first circuit board 310. The second securing member 362c may penetrate the first circuit board 310, may be inserted into the first circuit board 310, or may be secured to the first circuit board 310.

For example, a head of the second securing member 362c may contact a first surface of the first circuit board 310 and a shaft, which extends from the head, of the second securing member 362c may penetrate from the first surface of the first circuit board 310 to a second surface of the first circuit board 310.

In an embodiment, the second securing member 362c may be secured to the first securing member 361c. As the second securing member 362c is secured to the first securing member 361c, the second securing member 362c may secure the first circuit board 310 to the first securing member 361c and the external structure 305.

In an embodiment, the third securing member 363c may penetrate the second circuit board 320. For example, the second circuit board 320 may include at least one opening 313c that penetrates in the vertical direction (e.g., a W-axis direction). The third securing member 363c may extend from the external structure 305 by penetrating the opening 313c and may penetrate the second circuit board 320.

In an embodiment, the fourth securing member 364c may be disposed on the pressurizing structure 350. The fourth securing member 364c may be disposed on the pressurizing structure 350, may be inserted into the pressurizing structure 350, or may be secured to the pressurizing structure 350.

For example, a head of the fourth securing member 364c may contact a first surface of the pressurizing structure 350 and a shaft, which extends from the head, of the fourth securing member 364c may penetrate from the first surface of the pressurizing structure 350 to a second surface of the pressurizing structure 350. Without being limited thereto, at least a portion of the fourth securing member 364c may be secured or connected to the pressurizing structure 350 and may be integrally formed therewith as one.

In an embodiment, the fourth securing member 364c may be secured to the third securing member 363c. As the fourth securing member 364c is secured to the third securing member 363c, the fourth securing member 364c may secure the pressurizing structure 350 to the third securing member 363c and the external structure 305.

In an embodiment, as the third securing member 363c penetrates the opening 313c of the second circuit board 320, a plurality of securing members 361c, 362c, 363c, and 364c may not be secured to or supported by the second circuit board 320 and may be secured to or supported by the first circuit board 310 or the external structure 305. The pressurizing structure 350 may transfer a pre-load or a portion of a reaction force of the pre-load to the first circuit board 310 or the external structure 305 and may reduce or minimize a force transferred to the second circuit board 320. The PCB assembly 300 including different circuit boards (e.g., the first circuit board 310 and the second circuit board 320) may provide improved durability by reducing or minimizing stress applied to the connecting member 340 through the plurality of securing members 361c, 362c, 363c, and 364c.

In an embodiment, in the PCB assembly 300 including the plurality of securing members 361c, 362c, 363c, and 364c, some structures (e.g., the third securing member 363c and the fourth securing member 364c) for supporting or securing the pressurizing structure 350 and that are not fixed to (e.g., in an unfixed state with respect to, separated from, spaced apart from, etc.) the first circuit board 310 and the second circuit board 320 may be supported by the external structure 305.

In an embodiment, since stress by the pressurizing structure 350 is not transferred to the first circuit board 310, the second circuit board 320, and the connecting member 340, the PCB assembly 300 including the plurality of securing members 361c, 362c, 363c, and 364c may reduce the durability problem due to pre-load application of the pressurizing structure 350 and the intensity control of a pre-load of the pressurizing structure 350 may be less limited. The PCB assembly 300 including the plurality of securing members 361c, 362c, 363c, and 364c may allow relatively easy circuit board design, the pressurizing structure 350 may apply a greater pre-load, and/or may provide improved durability of the PCB assembly 300.

In an embodiment, the first circuit board 310 may be a high-specification circuit board on which the electronic component 311 is disposed and the second circuit board 320 may be a relatively low-specification circuit board compared to the first circuit board 310. The PCB assembly 300 including the plurality of securing members 361, 362c, 363c, and 364c may provide further improved design easiness of the PCB assembly 300 and economic feasibility in fabrication by forming the opening 313c in the second circuit board 320.

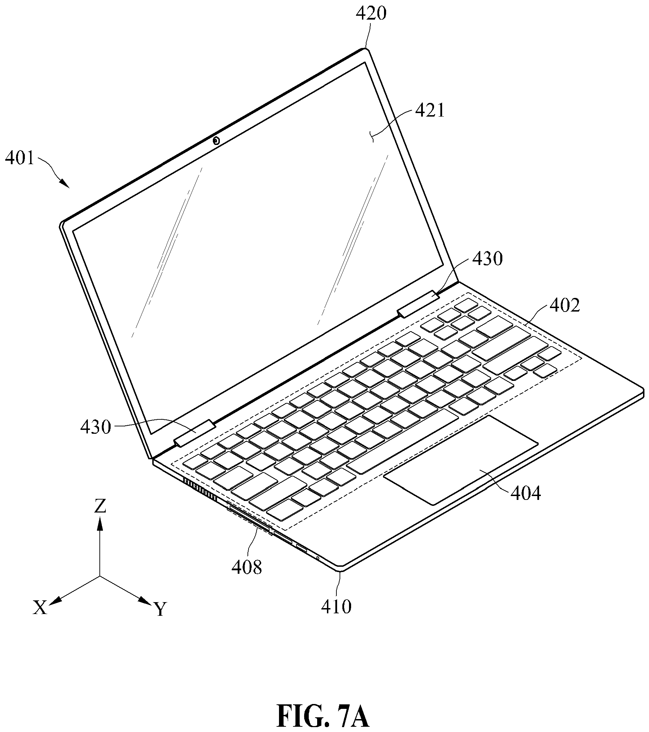

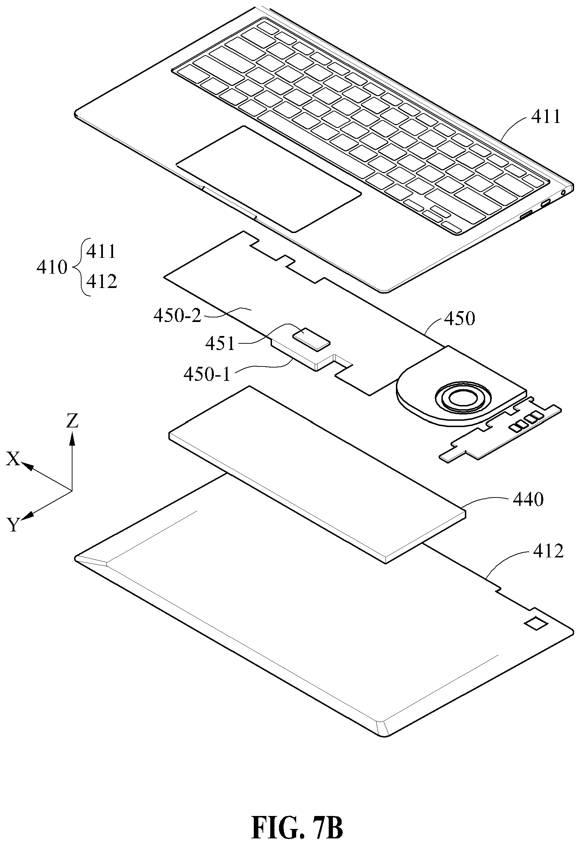

FIG. 7A is a perspective view of an electronic device 401 according to an embodiment and FIG. 7B is an exploded perspective view of a first housing 410 of the electronic device 401 according to an embodiment.

Referring to FIGS. 7A and 7B, the electronic device 401 (e.g., the electronic device 101 of FIG. 1) in an embodiment may include the first housing 410, a second housing 420, a connector 430, a battery 440 (e.g., the battery 189 of FIG. 1), and a PCB assembly 450.

In an embodiment, the first housing 410 may include a keyboard 402, a touchpad 404, and an antenna module 408. The keyboard 402 (e.g., the input module 150 of FIG. 1) may include a plurality of keys. The keyboard 402 may receive numeric or character information. The keyboard 402 may include a plurality of input keys and function keys for setting various functions of the electronic device 401. The function keys may include an arrow key, a volume key, and/or a shortcut key, which are set to perform a designated function. The keyboard 402 may include one of a qwerty keypad, a 3*4 keypad, a 4*3 keypad, or a touch key.

In an embodiment, the touchpad 404 may replace the function of a mouse. The touchpad 404 may input an instruction for selecting or executing an application displayed on a display 421 (e.g., the display module 160 of FIG. 1).

In an embodiment, the antenna module 408 (e.g., the antenna module 197 of FIG. 1) may transmit or receive a signal or power to or from an external electronic device (e.g., the electronic devices 102 and 104 and/or the server 108 of FIG. 1).

In an embodiment, the first housing 410 may include at least one electronic component. For example, the electronic component of the first housing 410 may include the processor 120, the memory 130, and the sensor module 176 of FIG. 1 and/or other electronic components.

In an embodiment, the display 421 may be disposed on the second housing 420. The display 421 may include a screen for displaying information to be provided for a user or information input by the user by using various menus of the electronic device 401 and the keyboard 402. The screen may include at least one of a liquid crystal display (LCD), an organic light-emitting diode (OLED) display, an active-matrix organic light-emitting diode (AMOLED) display, a flexible display, or a transparent display. The screen may provide, based on use of the electronic device 401, at least one of various screens, for example, a home screen, a menu screen, a lock screen, a game screen, a webpage screen, a call screen, or a music or video play screen.

In an embodiment, the second housing 420 may include at least one electronic component therein. For example, the electronic component of the second housing 420 may include the camera module 180 and the sound output module 155 of FIG. 1 and/or other electronic components.

In an embodiment, the connector 430 may connect the first housing 410 to the second housing 420. The connector 430 may rotate the first housing 410 and the second housing 420 relative to each other.

For example, the electronic device 401 may change between a closed state and an open state, in which the first housing 410 and the second housing 420 practically face each other in the closed state and one of the first housing 410 and the second housing 420 rotates with respect to the other.

In an embodiment, the connector 430 may include a hinge structure configured to mechanically connect the first housing 410 to the second housing 420. The connector 430 may electrically connect the first housing 410 to the second housing 420. For example, the connector 430 may include a flexible PCB (FPCB).

In one embodiment, the first housing 410 may include a front cover 411 and a rear cover 412. The front cover 411 may form the exterior of the front surface (e.g., the +z direction surface) of the first housing 410.

For example, the keyboard 402 and/or the touchpad 404 may be disposed on the front cover 411. The rear cover 412 may form the exterior of the rear surface (e.g., the -z direction surface) of the first housing 410. The front cover 411 and/or the rear cover 412 may include plastic and/or a metal material. However, this is only an example, and the materials of the front cover 411 and the rear cover 412 are not limited thereto.

In an embodiment, as the front cover 411 is fastened to the rear cover 412, a space in which various components may be disposed may be formed inside the first housing 410.

For example, the front cover 411 may be fastened to the rear cover 412 substantially along the circumference thereof to form a space therebetween. The battery 440 and the PCB 450 may be disposed in the inner space of the first housing 410. However, this is only an example, and a component arranged in the inner space of the first housing 410 is not limited thereto.

In one embodiment, the battery 440 may supply power to at least one component of the electronic device 401. Various electronic components for implementing a function of the electronic device 401 may be disposed on the PCB assembly 450. The battery 440 and/or the PCB assembly 450 may be disposed and fixed in the inner space of the first housing 410. For example, the PCB assembly 450 may be connected and fixed to the front cover 411.

In an embodiment, the PCB assembly 450 may be formed by coupling different PCBs and for example, the PCB assembly 450 may include a first circuit board 450-1 and a second circuit board 450-2.

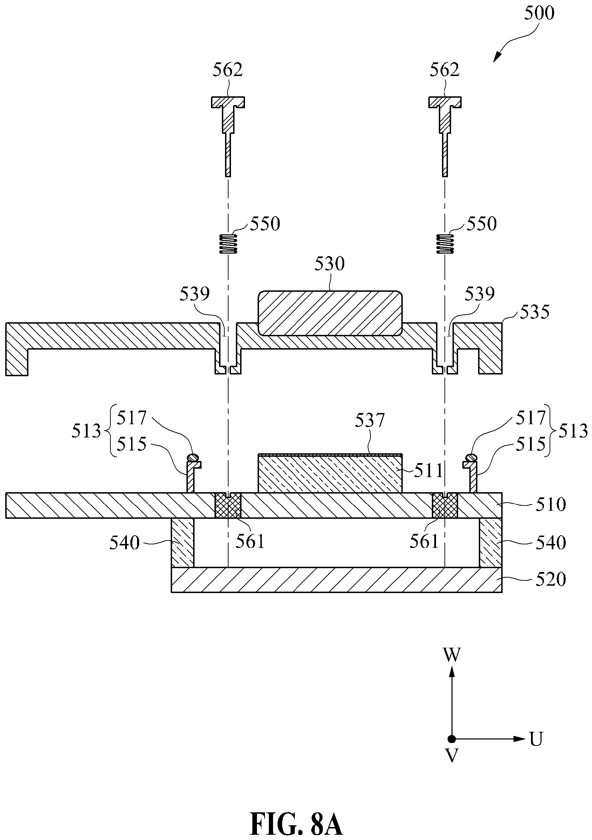

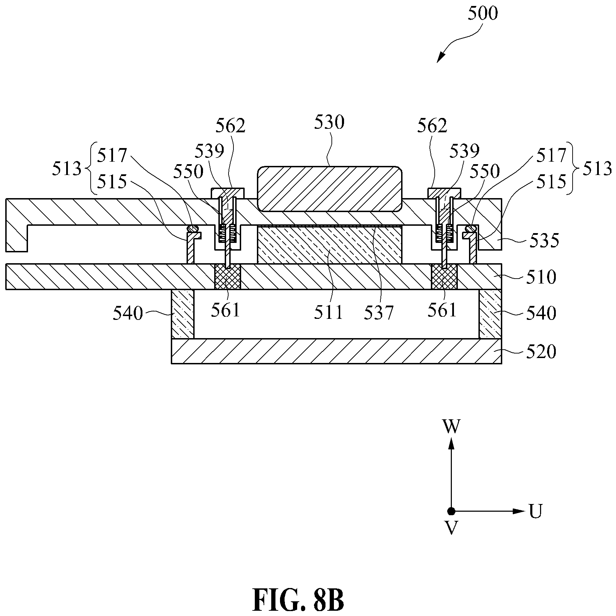

In an embodiment, the second circuit board 450-2 may include at least one electronic component 451 and may include a different structure (e.g., a thermal module 530 or a pressurizing structure 550 of FIG. 8) associated therewith.

In an embodiment, the electronic component 451 may include various circuits or some components for driving or controlling the electronic device 401. For example, the electronic component 451 may be an integrated circuit. The electronic component 451 may generate heat due to operation and may need to be cooled.

In an embodiment, the electronic component 451 may be a CPU (e.g., the processor 120 or the main processor 121 of FIG. 1) or an AP, which is an element for performing key operations of the electronic device 401.

In an embodiment, the electronic component 451 may be a wireless communication circuit (e.g., the wireless communication module 192 of FIG. 1). The wireless communication circuit may communicate with, for example, an external device (e.g., the electronic device 104 of FIG. 1). The electronic device 401 may include an antenna (e.g., the antenna module 197 of FIG. 1) and the wireless communication circuit may be electrically connected to an antenna structure. The wireless communication circuit may generate a signal to be transmitted through the antenna structure or detect a signal received through the antenna structure. For example, the PCB assembly 450 may include ground and the ground of the PCB assembly 450 may function as ground of the antenna structure implemented using the wireless communication circuit. However, the example is not limited thereto and the electronic component 451 may be a graphics component (e.g., a portion of the display module 160 of FIG. 1).

Hereinafter, based on the description of the electronic device 401, a configuration and a structure of a PCB assembly in an embodiment are described. Hereinafter, to describe the electronic device 401, a duplicated description with the electronic device 401 is omitted and a portion of the configuration or a structure may be replaced, added, or omitted within a scope in which one of ordinary skill in the art may easily understand.

FIG. 8A is a cross-sectional view of a PCB assembly 500 in a disassembled state according to an embodiment and FIG. 8B is a cross-sectional view of the PCB assembly 500 according to an embodiment.

Referring to FIGS. 8A and 8B, the PCB assembly 500 (e.g., the PCB assembly 450 of FIG. 7B) may include at least a portion of a first circuit board 510 (e.g., the first circuit board 450-1), a second circuit board 520 (e.g., the second circuit board 450-2 of FIG. 7B), a thermal module 530, a bracket 535, a sealing structure 513, and a pressurizing structure 550.

In an embodiment, at least one component or feature of embodiments described above may be coupled to the PCB assembly 500.

In an embodiment, the PCB assembly 500 may be a PCB assembly 500 including different PCBs where the first circuit board 510 is coupled or connected to the second circuit board 520. The first circuit board 510 and the second circuit board 520 may be separate circuit boards and for example, the PCB assembly 500 may include a master circuit board and an auxiliary circuit board or may include a main circuit board and a sub-circuit board.

In an embodiment, the first circuit board 510 and the second circuit board 520 may be connected to each other through a connecting member 540. The connecting member 540 may physically bond the first circuit board 510 and the second circuit board 520 to each other or may electrically and communicably connect the first circuit board 510 to the second circuit board 520. For example, the connecting member 540 may be a soldering member or an interposer member for connecting wiring between the first circuit board 510 and the second circuit board 520. The connecting member 540 may be formed of at least one of silicone, glass, a polymer compound, or a solder paste.

In an embodiment, the PCB assembly 500 may include an electronic component 511 (e.g., the electronic component 451 of FIG. 7B). However, the electronic component 511 described herein is only one of various components included in the PCB assembly 500. In actual implementation, the PCB assembly 500 may include one or more electronic components of various types, structures, and arrangements.

For example, the electronic component 511 may refer to a component, which requires heat protection or temperature control by the thermal module 530, of various components included in the PCB assembly 500. For example, the electronic component 511 may be a CPU or an AP configured to perform key operations, a CP, a wireless communication circuit, or a graphics element.

In an embodiment, the electronic component 511 may be disposed on the first circuit board 510. For example, the first circuit board 510 may be a core circuit board or a main circuit board. The first circuit board 510 may be a relatively high-specification or highly integrated circuit board compared to the second circuit board 520. The second circuit board 520 may be connected to the first circuit board 510. For example, the second circuit board 520 may be a sub circuit board or an auxiliary circuit board. The second circuit board 520 may be a relatively low-specification or less integrated circuit board compared to the first circuit board 510. Easiness and economic feasibility in fabrication of the PCB assembly 500 may be secured by including the first circuit board 510, in which the electronic component 511 is disposed, and the second circuit board 520 connected to the first circuit board 510 in the PCB assembly 500.

In an embodiment, the thermal module 530 may absorb heat from the electronic component 511. For example, the thermal module 530 may be a cooling module or a heat protection module. The thermal module 530 may absorb external heat or heat generated due to operation of the electronic component 511. Alternatively, the thermal module 530 may control the temperature of the electronic component 511 or the PCB assembly 500 to prevent the electronic component 511 from overheating. The thermal module 530 may be thermally connected to the electronic component 511 directly or indirectly through another component (e.g., the bracket 535 and/or a TIM 537) for heat exchange.

In an embodiment, the TIM 537 may be disposed between the electronic component 511 and the bracket 535 or the thermal module 530. The TIM 537 may improve heat conductivity from the electronic component 511 to the bracket 535 or the thermal module 530.

In an embodiment, the TIM 537 may be applied and cured in a cream or paste state between the pressurizing structure 550 and the electronic component 511. However, the example is not limited thereto.

In an embodiment, the bracket 535 may be a support structure to which the thermal module 530 is connected or secured. A first surface (e.g., a surface in the +W direction) of the bracket 535 may be connected to the thermal module 530 and a second surface (e.g., a surface in the -W direction) opposite to the first surface may be connected to the electronic component 511. The TIM 537 may be disposed between the bracket 535 and the electronic component 511 and at least a portion of heat generated by the electronic component 511 may move to the bracket 535 or the thermal module 530 through the TIM 537.

In an embodiment, the bracket 535 may be disposed at a position facing the first circuit board 510. Based on the first circuit board 510, the bracket 535 and the thermal module 530 may be disposed in a direction (e.g., the +W direction) in which the electronic component 511 is disposed and the second circuit board 520 and the connecting member 540 may be disposed in an opposite direction (e.g., the -W direction) thereto. As the second circuit board 520 is disposed in the position opposite to the electronic component 511, the thermal module 530, and the bracket 535, thermal impact with the electronic component 511 and/or impact of an electromagnetic wave may decrease.

In an embodiment, the bracket 535 may include an opening 539. The opening 539 may be a space into which the pressurizing structure 550 and/or one securing member (e.g., a second securing member 562) is inserted.

In an embodiment, the bracket 535 may be formed of a thermally conductive material, may receive heat generated by the electronic component 511, and may perform a heat protection function.

In an embodiment, the thermal module 530 may cool the bracket 535 that substantially contacts the thermal module 530 and by cooling the bracket 535, the thermal module 530 may indirectly absorb heat from the electronic component 511 and may cool the electronic component 511 and/or the PCB assembly 500.

In an embodiment, a sealing structure 513 may include a shield can 515 and a shielding structure 517. The sealing structure 513 may physically, electrically, and/or communicatively isolate the electronic component 511 from the outside.

In an embodiment, the shield can 515 may be disposed between the bracket 535 and the first circuit board 510 and may enclose the electronic component 511. The shielding structure 517 may be disposed between the shield can 515 and the bracket 535 and may substantially shield the inside and outside of the shield can 515.

In an embodiment, the shield can 515 may prevent a foreign material, such as water, water vapor, and dust, from entering the space enclosed by the shield can 515. Alternatively, the shield can 515 may protect the electronic component 511 to prevent external impact from being transmitted to the electronic component 511.

In an embodiment, the shield can 515 may improve an effect of heat protection or cooling inside the shield can 515 by isolating the electronic component 511 and an area adjacent thereto from the outside. Alternatively, the shield can 515 may prevent an electromagnetic wave from entering the electronic component 511 and/or the shield can 515 may seal the electromagnetic wave generated by the electronic component 511 to prevent the electromagnetic wave from being emitted to the outside.

In an embodiment, the shield can 515 may be formed of an electromagnetic shielding material, a nonconductor, or an insulator. For example, the shield can 515 may be formed of graphite, a metal compound, or a polymer material.

In an embodiment, the shield can 515 may be connected to the first circuit board 510 and the shielding structure 517 may be disposed between the shield can 515 and the bracket 535. The shielding structure 517 may shield the inside of the shield can 515 from the outside.

In an embodiment, the PCB assembly 500 may include a plurality of securing members 561 and 562. For example, the plurality of securing members 561 and 562 may include a first securing member 561 and a second securing member 562. The bracket 535 may be secured to the first circuit board 510 through the first securing member 561 and the second securing member 562.

In an embodiment, the first securing member 561 may be a support structure supported by the first circuit board 510. The first securing member 561 may be inserted into the first circuit board 510 and may be secured to the first circuit board 510. The first securing member 561 may self-clinch to the first circuit board 510 and for example, the first securing member 561 may be a clinching nut, an insert nut, or a swage nut.

In an embodiment, the second securing member 562 may be disposed on the bracket 535. The second securing member 562 may be secured to the first securing member 561 and may secure the bracket 535 to the first securing member 561. The second securing member 562 may have a structure that is able to be inserted or secured to the first securing member 561 and/or the opening 539 of the bracket 535. For example, the second securing member 562 may be an external thread or a bolt. Without being limited thereto, the second securing member 562 may be a structure in the shape of a nail, a cone, or a pillar having a circular or polygonal cross-section.

In an embodiment, the second securing member 562 may penetrate at least a portion of the first securing member 561, the opening 539 of the bracket 535, and the pressurizing structure 550. For example, a head of the second securing member 562 may contact a surface of the bracket 535 and a shaft, which extends from the head, of the second securing member 562 may penetrate from the opening 539 of the bracket 535. Without being limited thereto, at least a portion of the second securing member 562 may be secured or connected to the bracket 535 and may be integrally formed therewith as one.

In an embodiment, the pressurizing structure 550 may apply a pre-load to the thermal module 530 and/or the electronic component 511 to reduce or minimize the contact heat resistance between the thermal module 530 and the electronic component 511.

In an embodiment, the pressurizing structure 550 may apply a pre-load to the thermal module 530 in a direction toward the electronic component 511. For example, as the pressurizing structure 550 presses the bracket 535 in a direction (e.g., the -W direction) facing the first circuit board 510, the thermal module 530 connected to the bracket 535 may apply a pre-load to the electronic component 511 disposed on the first circuit board 510. Through the pressurizing structure 550, the thermal module 530 and the electronic component 511 may closely contact each other.

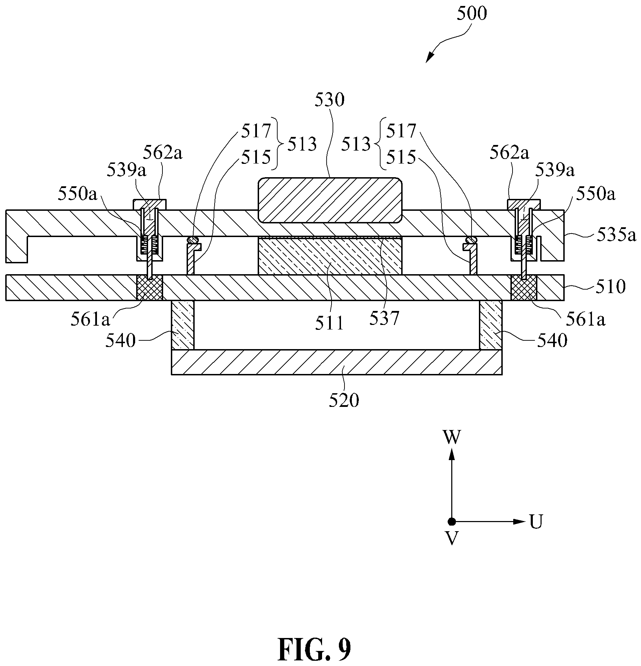

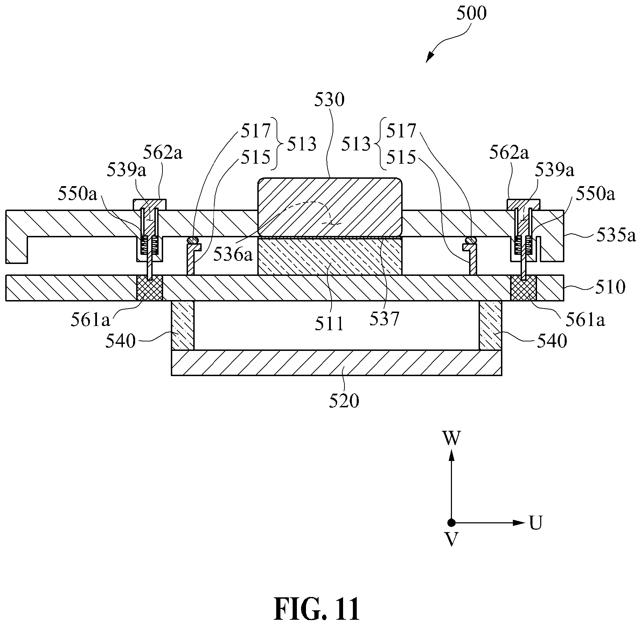

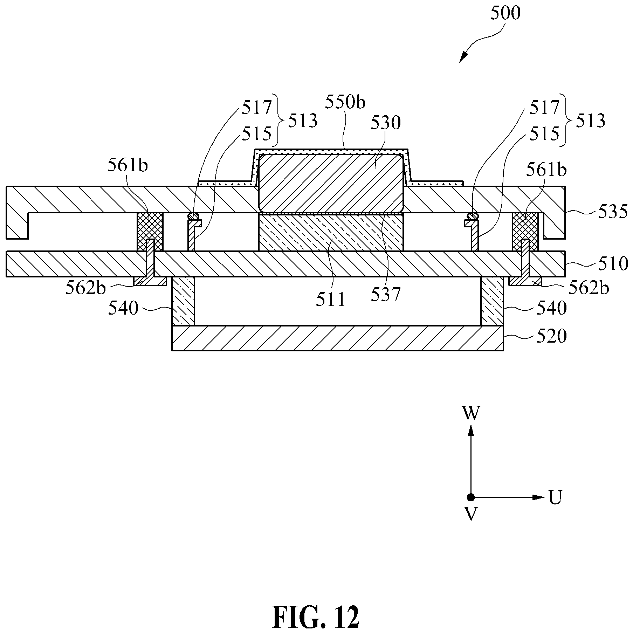

In an embodiment, the pressurizing structure 550 may be a spring-shaped elastic body. The pressurizing structure 550 may be disposed between the second securing member 562 and the bracket 535. Without being limited thereto, the pressurizing structure 550 may include various arrangements (e.g., a pressurizing structure 550a of FIG. 9 or FIG. 11) and structures (e.g., a pressurizing structure 550b of FIG. 12).

In an embodiment, the pressurizing structure 550 may be pressed by the second securing member 562 and may be compressed. When the first securing member 561 and the second securing member 562 are secured to each other, a portion of the bracket 535 and the pressurizing structure 550 may be disposed therebetween. As the first securing member 561 and the second securing member 562 are secured, the pressurizing structure 550 may be supported by the first circuit board 510 in which the first securing member 561 is disposed.

In an embodiment, when the pressurizing structure 550 is compressed by the second securing member 562, the bracket 535 may be pressed by applying an elastic force to the bracket 535 in a direction (e.g., the -W direction). As the pressurizing structure 550 presses the bracket 535, the bracket 535 may apply a pre-load in a direction (e.g., -W direction) facing the first circuit board 510 and the pressurizing structure 550 may apply a pre-load in a direction in which the thermal module 530 connected to the bracket 535 faces the electronic component 511.

In an embodiment, the pressurizing structure 550 may apply stress to the first circuit board 510 or the second circuit board 520 based on the shape, arrangement, and/or structure of the plurality of securing members 561 and 562. For example, when the first securing member 561 is provided at the second circuit board 520 and the bracket 535 and the pressurizing structure 550 are supported by the second circuit board 520, the second circuit board 520 may receive a reaction force corresponding to the pre-load.

In an embodiment, the stress transferred to the first circuit board 510 or the second circuit board 520 may affect the connecting member 540. The stress may cause at least partial damage or cracks of the connecting member 540. When the connecting member 540 is damaged, a poor connection or disconnection between the first circuit board 510 and the second circuit board 520 may occur.

In an embodiment, when the pressurizing structure 550 is not fixed to the second circuit board 520 (e.g., not attached to, not adhered to, removed from, in an unfixed state with respect to, separated from, spaced apart from, etc.), the pressurizing structure 550 may be supported by the first circuit board 510. Alternatively, the pressurizing structure 550 may be not fixed to or supported by the second circuit board 520. Alternatively, the pressurizing structure 550 may not contact the second circuit board 520. As the pressurizing structure 550 is fixed to the first circuit board 510 and not the second circuit board 520, the pressurizing structure 550 may suppress or minimize stress transferred to the connecting member 540.

In an embodiment, a plurality of securing members 561 and 562 may not be secured to or supported by the second circuit board 520 and may be directly or indirectly secured to or supported by the first circuit board 510. The pressurizing structure 550 may transfer a pre-load or a portion of a reaction force of the pre-load to the first circuit board 510 and may reduce or minimize a force transferred to the second circuit board 520. The PCB assembly 500 including different circuit boards (e.g., the first circuit board 510 and the second circuit board 520) may provide improved durability by reducing or minimizing stress applied to the connecting member 540 through the plurality of securing members 561 and 562.

In an embodiment, the first securing member 561 and the second securing member 562 may be disposed within the shield can 515. The opening 539 of the bracket 535 may be disposed at a position corresponding to the first securing member 561 to face the first securing member 561 in the inside of the shield can 515, and the second securing member 562 and the pressurizing structure 550 may be disposed in the opening 539 of the bracket 535. Inside of the shield can 515, the position of the pressurizing structure 550 may be relatively close to the thermal module 530 and the electronic component 511 compared to the outside of the shield can 515.

In an embodiment, as the first securing member 561 and the second securing member 562 are disposed in the inside of the shield can 515, the pressurizing structure 550 may be disposed relatively close to the thermal module 530, and thus, the pressurizing structure 550 may more efficiently apply a pre-load to the thermal module 530.

For example, as the pressurizing structure 550 is formed relatively away from the thermal module 530, an elastic force applied to the pressurizing structure 550 may increase to make a targeted pre-load. When the elastic force increases, the stress transferred to the first circuit board 510, the second circuit board 520, or the connecting member 540 may increase. Alternatively, when the pressurizing structure 550 relatively moves away from the thermal module 530, the size of an area to which the elastic force is transferred may increase and the area to which a predetermined intensity of stress is applied in the PCB assembly 500 may increase.

In an embodiment, in the PCB assembly 500 including the plurality of securing members 561 and 562, by disposing the first securing member 561 and the second securing member 562 in the inner space of the shield can 515, a distance between the pressurizing structure 550 and the thermal module 530 may relatively decrease and through this, the PCB assembly 500 may provide more stably improved durability.

FIG. 9 is a cross-sectional view of a PCB assembly 500 according to an embodiment.

Referring to FIG. 9, the PCB assembly 500 in an embodiment may include at least a portion of a plurality of securing members 561a and 562a, an opening 539a, and a pressurizing structure 550a.

In the description of FIG. 9, the structure and configuration of the PCB assembly 500 are described and repeated descriptions with PCB assemblies described above may be omitted. Furthermore, this is only an example and a portion of the configuration or a structure may be replaced, added, or omitted within a scope in which one of ordinary skill in the art may easily understand with reference to the following drawings and descriptions. In addition, at least one component or feature of embodiments described above may be coupled to the PCB assembly 500.

In an embodiment, the first securing member 561a and the second securing member 562a may be disposed on the outside of the shield can 515. The opening 539a of the bracket 535 may be disposed at a position corresponding to the first securing member 561a to face the first securing member 561a at the outside of the shield can 515, and the second securing member 562a and the pressurizing structure 550a may be disposed in the opening 539a of the bracket 535.

In an embodiment, when the first securing member 561a and the second securing member 562a are disposed in the inside of the shield can 515, the inside of the shield can 515 may not be substantially sealed or the sealing performance may be degraded through the opening 539a of the bracket 535 or an area that connects the first securing member 561a, the second securing member 562a, and the pressurizing structure 550a to another structure.

In an embodiment, the PCB assembly 500 may secure the function of the sealing structure 513 by disposing the first securing member 561a and the second securing member 562a at the outside of the shield can 515. As described above, the shield can 515 and the shielding structure 517 may physically, electrically, and/or communicatively separate the electronic component 511 from the outside, may protect the electronic component 511, or may improve heat protection or cooling performance of the electronic component 511 through the thermal module 530.

In an embodiment, in the PCB assembly 500 including the plurality of securing members 561a and 562a, by disposing the first securing member 561a and the second securing member 562a in the outer space of the shield can 515, the function of the shielding structure 517 and the shield can 515 of the sealing structure 513 may improve and through this, the PCB assembly 500 may provide more stably improved performance and durability.

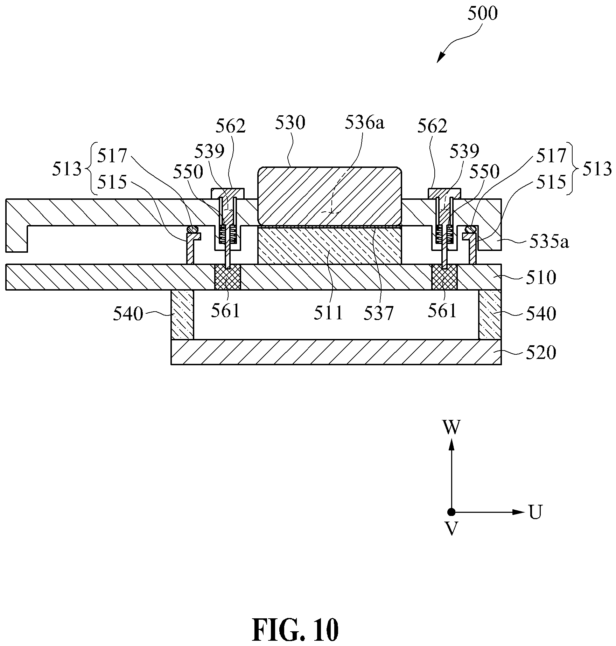

FIG. 10 is a cross-sectional view of a PCB assembly 500 according to an embodiment.

Referring to FIG. 10, the PCB assembly 500 in an embodiment may include a thermal module hole 536.

In the description of FIG. 10, the structure and configuration of the PCB assembly 500 are described and repeated descriptions with PCB assemblies described above may be omitted. Furthermore, this is only an example and a portion of the configuration or a structure may be replaced, added, or omitted within a scope in which one of ordinary skill in the art may easily understand with reference to the following drawings and descriptions. In addition, at least one component or feature of embodiments described above may be coupled to the PCB assembly 500.

In an embodiment, the thermal module hole 536 may be a seating recess into which the thermal module 530 is inserted and secured. The thermal module hole 536 may be formed in the bracket 535 from a surface facing the first circuit board 510 to the opposite surface thereto. The thermal module hole 536 may be disposed at a position facing the electronic component 511 of the first circuit board 510.

In an embodiment, the thermal module 530 may face the electronic component 511 through the thermal module hole 536. The TIM 537 may be provided between the thermal module 530 and the electronic component 511 and other components (e.g., a partial area of the bracket 535) may be omitted.

In an embodiment, when the PCB assembly 500 does not include the thermal module hole 536, for example, when the thermal module 530 contacts a surface of the bracket 535 (e.g., see FIGS. 8A and 8B or FIG. 9), the heat exchange efficiency of the thermal module 530 may be degraded. Alternatively, when the heat exchange efficiency thereof is degraded, the size of a pre-load required by the PCB assembly 500 to the pressurizing structure 550 may increase.

In an embodiment, as the PCB assembly 500 includes the thermal module hole 536, the thermal module 530 may increase the heat exchange efficiency thereof by directly contacting the electronic component 511 or substantially directly contacting the electronic component 511 only through the TIM 537, and through this, the PCB assembly 500 may improve heat protection or cooling performance of the electronic component 511 of the thermal module 530 or the pressurizing structure 550 may achieve a targeted goal with a relatively small pre-load.

FIG. 11 is a cross-sectional view of a PCB assembly 500 according to an embodiment.

Referring to FIG. 11, the PCB assembly 500 in an embodiment may include at least a portion of the plurality of securing members 561a and 562a, the thermal module hole 536, the opening 539a, and the pressurizing structure 550a.

In the description of FIG. 11, the structure and configuration of the PCB assembly 500 are described and repeated descriptions with PCB assemblies described above may be omitted. Furthermore, this is only an example and a portion of the configuration or a structure may be replaced, added, or omitted within a scope in which one of ordinary skill in the art may easily understand with reference to the following drawings and descriptions. In addition, at least one component or feature of embodiments described above may be coupled to the PCB assembly 500.

In an embodiment, when the first securing member 561a and the second securing member 562a are disposed at the outside of the shield can 515 (e.g., the PCB assembly 500 of FIG. 9), the function of the sealing structure 513 may be secured. However, the size of a pre-load provided to the thermal module 530 may decrease or a limitation may be imposed on providing the pre-load.

In an embodiment, when the thermal module 530 is disposed in the thermal module hole 536 (e.g., the PCB assembly 500 of FIG. 10), the heat exchange efficiency between the thermal module 530 and the electronic component 511 may increase. When the PCB assembly 500 includes the thermal module hole 536, a targeted goal may be achieved even if the pressurizing structure 550a make a relatively smaller pre-load.

In an embodiment, in the PCB assembly 500 including the plurality of securing members 561a and 562a, by disposing the first securing member 561a and the second securing member 562a in the outer space of the shield can 515, the function of the shielding structure 517 and the shield can 515 of the sealing structure 513 may improve and the PCB assembly 500 may improve heat protection or cooling performance of the electronic component 511 of the thermal module 530 as the PCB assembly 500 includes the thermal module hole 536. In addition, by improving the heat exchange efficiency through the thermal module hole 536, the PCB assembly 500 may solve the pre-load degradation problem that may occur as the first securing member 561a and the second securing member 562a are disposed at the outer space of the shield can 515.

FIG. 12 is a cross-sectional view of a PCB assembly 500 according to an embodiment.

Referring to FIG. 12, the PCB assembly 500 in an embodiment may include at least a portion of a plurality of securing members 561b and 562b and a pressurizing structure 550b.

In the description of FIG. 12, the structure and configuration of the PCB assembly 500 are described and repeated descriptions with PCB assemblies described above may be omitted. Furthermore, this is only an example and a portion of the configuration or a structure may be replaced, added, or omitted within a scope in which one of ordinary skill in the art may easily understand with reference to the following drawings and descriptions. In addition, at least one component or feature of embodiments described above may be coupled to the PCB assembly 500.

In an embodiment, the first securing member 561b may be a support structure supported by the bracket 535. For example, the first securing member 561b may be an internal thread, a nut, or a support body that is secured to the bracket 535 and has a fitment structure.

In an embodiment, in the first securing member 561b, a first surface may be secured to or supported by the bracket 535 and a second surface opposite to the first surface may have a pillar shape extending in a direction (e.g., the -W direction) away from the bracket 535.

In an embodiment, the second securing member 562b may have a structure that may be inserted into or secured to the first securing member 561b. For example, the second securing member 562b may be an external thread or a bolt. Without being limited thereto, the second securing member 562b may be a structure in the shape of a nail, a cone, or a pillar having a circular or polygonal cross-section.

In an embodiment, the second securing member 562b may be disposed on the first circuit board 510. The second securing member 562b may penetrate the first circuit board 510, may be inserted into the first circuit board 510, or may be secured to the first circuit board 510.

For example, a head of the second securing member 562b may contact a first surface of the first circuit board 510 and a shaft, which extends from the head, of the second securing member 562b may penetrate from the first surface of the first circuit board 510 to a second surface of the first circuit board 510.

In an embodiment, the second securing member 562b may be secured to the first securing member 561b. As the second securing member 562b is secured to the first securing member 561b, the second securing member 562b may secure the first circuit board 510 to the bracket 535.

In an embodiment, in the PCB assembly 500 including the plurality of securing members 561b and 562b, the bracket 535 and the pressurizing structure 550b connected to the bracket 535 in an unfixed state with respect to (e.g., not attached to, not adhered to, removed from, etc.) the second circuit board 520 may be indirectly supported by the first circuit board 510 through the plurality of securing members 561b and 562b.

In an embodiment, the pressurizing structure 550b may be a plate-shaped elastic body. Alternatively, the pressurizing structure 550b may be tape or film. The pressurizing structure 550b may cover at least a portion of a surface of the bracket 535 and the thermal module 530 and may be attached to the bracket 535.

In an embodiment, the pressurizing structure 550b may be disposed on the surface opposite to a surface facing the electronic component 511 in the bracket 535 and the thermal module 530. The pressurizing structure 550b may apply a pre-load to the thermal module 530 in a direction facing the electronic component 511.

As illustrated in FIG. 12, the thermal module 530 may protrude by a predetermined gap from the upper surface of the bracket 535. When the pressurizing structure 550b is connected to the thermal module 530 and the upper surface of the bracket 535 by substantially closely contacting the thermal module 530 and the bracket 535, the pressurizing structure 550b may press the thermal module 530 in a direction of the bracket 535 by its own elastic force or resilient force.

In an embodiment, the pressurizing structure 550b may be supported by the bracket 535. As described above, since the bracket 535 is secured to the first circuit board 510 through the first securing member 561b and the second securing member 562b, accordingly, the pressurizing structure 550b may be supported by the first circuit board 510 through the first securing member 561b and the second securing member 562b.

In an embodiment, in the PCB assembly 500 including the plurality of securing members 561b and 562b and the pressurizing structure 550b, since stress by the pressurizing structure 550b is mainly transferred to the bracket 535 and indirectly transferred to the first circuit board 510, stress transferred to the second circuit board 520 and the connecting member 540 may be relatively reduced or minimized. Alternatively, the PCB assembly 500 including the plurality of securing members 561b and 562b may provide relatively easy circuit board design and/or further improved durability of the PCB assembly 500.

In an embodiment, the pressurizing structure 550b may be relatively simply and easily formed and assembled, the space efficiency may be improved, and/or the pressurizing structure 550b may be easily managed. The PCB assembly 500 including the pressurizing structure 550b may have an advantage in design and fabrication.

The PCB assembly in an embodiment may include a first circuit board 310, an electronic component 311, 511 provided on the first circuit board 311, 511, a second circuit board 320 or 520 connected to the first circuit board 310 or 510, a thermal module 330 or 530 configured to absorb heat from the electronic component 311 or 511, and a pressurizing structure 350, 550, 550a, or 550b configured to apply a pre-load to the thermal module 330 or 530 in a direction toward the electronic component 311 or 511. In an embodiment, the pressurizing structure 350, 550, 550a, or 550b in an unfixed state with respect to (e.g., not attached to, not adhered to, removed from, separated from, spaced apart from, etc.) the second circuit board 320 or 520 may be supported by the first circuit board 310 or 510 or an external structure 305.

In an embodiment, the pressurizing structure 350 may penetrates the first circuit board 310.

In an embodiment, the pressurizing structure 350 may include a plate-shaped elastic body, a first surface of the pressurizing structure 350 is connected to the thermal module 330 and a second surface of the pressurizing structure that is opposite to the first surface is connected to the electronic component 311.

In an embodiment, the PCB assembly 300 may include a first securing member 361 supported by the external structure 305, a second securing member 362 disposed on the first circuit board 310 and securing the first circuit board 310 to the first securing member 361, and a third securing member 363 penetrating the pressurizing structure 350 and the second securing member 362 and the third securing member may be securing the pressurizing structure 350 to the first securing member 361.

In an embodiment, the PCB assembly 300 may include a first securing member 361a supported by the external structure 305, a second securing member 362a provided on the first circuit board 310 and securing the first circuit board 310 to the first securing member 361a, a third securing member 363a supported by the external structure 305 and penetrating the first circuit board 310, and a fourth securing member 364a provided on the pressurizing structure 350 and securing the pressurizing structure 350 to the third securing member 363a.

In an embodiment, the PCB assembly 300 may include a first securing member 361b supported by the external structure 305, a second securing member 362b provided on the first circuit board 310 and securing the first circuit board 310 to the first securing member 361b, a third securing member 363b provided on the first circuit board 310 and supported by the first circuit board 310, and a fourth securing member 364b provided on the pressurizing structure 350 and securing the pressurizing structure 350 to the third securing member 363b.

In an embodiment, the PCB assembly 300 may include a first securing member 361c supported by the external structure 305, a second securing member 362c provided on the first circuit board 310 and securing the first circuit board 310 to the first securing member 361c, a third securing member 363c supported by the external structure 305 and penetrating the second circuit board 320, and a fourth securing member 364c provided on the pressurizing structure 350 and securing the pressurizing structure 350 to the third securing member 363c.

In an embodiment, the PCB assembly 500 may include a bracket 535 connected to the thermal module 530 and secured to the first circuit board 510, a first securing member 561 or 561a provided on the first circuit board 510 and supported by the first circuit board 510, and a second securing member 562 or 562a provided on the bracket 535 and securing the bracket 535 to the first securing member 561 or 561a. In an embodiment, the pressurizing structure 550 or 550a may be provided between the bracket 535 and the second securing member 562 or 562a and supported by the first circuit board 510 as the first securing member 561 and the second securing member 562 or 562a are secured.

In an embodiment, the pressurizing structure 550 or 550a may be pressurized by the second securing member 562 or 562a and may apply a pre-load to the thermal module 530 in a direction toward the electronic component 511 by applying the pre-load to the bracket 535 in a direction toward the first circuit board 510.

In an embodiment, the PCB assembly 500 may include a shield can 515 provided between the bracket 535 and the first circuit board 510 and the shield 515 can at least partially enclosing the electronic component 511. In an embodiment, the first securing member 561 and the second securing member 562 may be provided at least partially inside the shield can 515.

In an embodiment, the PCB assembly 500 may include the shield can 515 provided between the bracket 535 and the first circuit board 510 and the shield 515 can at least partially enclosing the electronic component 511. In an embodiment, the first securing member 561a and the second securing member 562a may be provided at least partially outside of the shield can 515.

In an embodiment, the bracket 535 may include a thermal module hole 536 formed at a position corresponding to the electronic component 511. In an embodiment, the thermal module 530 may be provided in the thermal module hole 536 and substantially contacts the electronic component 511.

In an embodiment, the PCB assembly 500 may include the bracket 535 connected to the thermal module 530 and secured to the first circuit board 510, a first securing member 561b provided on the bracket 535 and supported by the bracket 535, and a second securing member 562b provided on the first circuit board 510 and securing the first circuit board 510 to the first securing member 561b.

In an embodiment, in the bracket 535 and the thermal module 530, the pressurizing structure 550b may be provided on a surface that is opposite to a surface facing the electronic component 511 and may apply a pre-load to the thermal module 530 in a direction toward the electronic component 511.

In an embodiment, the pressurizing structure 550b may be supported by the first circuit board 510 through the first securing member 561b and the securing member 562b.

The PCB assembly in an embodiment may include a first circuit board 310, an electronic component 311 is provided on the first circuit board 310, a second circuit board 320 connected to the first circuit board 310, a thermal module 330 configured to absorb heat from the electronic component 311, and a pressurizing structure 350 provided between the thermal module 330 and the electronic component 311 and configured to apply a pre-load to the thermal module 330 in a direction toward the electronic component 311. In an embodiment, the pressurizing structure 350 in an unfixed state with respect to (e.g., not attached to, not adhered to, removed from, separated from, spaced apart from, etc.) the second circuit board 320 is supported by an external structure 305 by penetrating the first circuit board 310.

In an embodiment, the PCB assembly may include a first securing member 361 supported by the external structure 305, a second securing member 362 provided on the first circuit board 310 and securing the first circuit board 310 to the first securing member 361, and a third securing member 363 penetrating the pressurizing structure 350 and the second securing member 362, and the third securing member 363 may be securing the pressurizing structure 350 to the first securing member 361.

In an embodiment, the PCB assembly may include a first securing member 361b supported by the external structure 305, a second securing member 362b provided on the first circuit board 310 and securing the first circuit board 310 to the first securing member 361b, a third securing member 363b provided on the first circuit board 310 and supported by the first circuit board 310, and a fourth securing member 364b provided on the pressurizing structure 350 and securing the pressurizing structure 350 to the third securing member 363b.

Alternatively, the PCB assembly in an embodiment may include a first circuit board 510,an electronic component 511 provided on the first circuit board 310, a second circuit board 520 connected to the first circuit board 510, a thermal module 530 configured to absorb heat from the electronic component 511, a bracket 535 connected to the thermal module 530 and secured to the first circuit board 510, a first securing member 561 or 561a provided on the first circuit board 510 and supported by the first circuit board 510, a second securing member 562 or 562a provided on the bracket 535 and securing the bracket 535 to the first securing member 561 or 561a, and a pressurizing structure 550 or 550a provided between the bracket 535 and the second securing member 562 or 562a and configured to apply a pre-load to the thermal module 530 in a direction toward the electronic component 511. In an embodiment, the pressurizing structure 350 in an unfixed state with respect to (e.g., not attached to, not adhered to, removed from, separated from, spaced apart from, etc.) the second circuit board 520 may be supported by the first circuit board 510.

In an embodiment, the PCB assembly may include a shield can 515 provided between the bracket 535 and the first circuit board 510 and at least partially enclosing the electronic component 511. In an embodiment, the first securing member 561a and the second securing member 562a may be provided at an outside of the shield can 515.

Embodiments are illustrated and described above, however, the present disclosure is not limited to the aforementioned embodiments. Various modifications may be implemented by one of ordinary skill in the art within a scope of the claims and such modifications shall not be understood.

## Claims

1. A printed circuit board (PCB) assembly 300 or 500 comprising:
a first circuit board 310 or 510;
an electronic component 311 or 511 provided on the first circuit board 310 or 510;
a second circuit board 320 or 520 connected to the first circuit board 310 or 510;
a thermal module 330 or 530 configured to absorb heat from the electronic component 311 or 511; and
a pressurizing structure 350, 550, 550a, or 550b configured to apply a pre-load to the thermal module 330 or 530 in a direction toward the electronic component 311 or 511,
wherein the pressurizing structure 350, 550, 550a, or 550b is separated from the second circuit board 320 or 520 and is supported by the first circuit board 310 or 510 or an external structure 305.

2. The PCB assembly 300 of claim 1, wherein the pressurizing structure 350 penetrates the first circuit board 310.

3. The PCB assembly 300 of claim 1 or 2, wherein the pressurizing structure 350 comprises a plate-shaped elastic body,
wherein a first surface of the pressurizing structure 350 is connected to the thermal module 330, and
wherein a second surface of the pressurizing structure 350 that is opposite to the first surface is connected to the electronic component 311.

4. The PCB assembly 300 of any of claims 1 to 3, further comprising:
a first securing member 361 supported by the external structure 305;
a second securing member 362 provided on the first circuit board 310 and securing the first circuit board 310 to the first securing member 361; and
a third securing member 363 penetrating the pressurizing structure 350 and the second securing member 362, the third securing member 363 securing the pressurizing structure 350 to the first securing member 361.

5. The PCB assembly 300 of any of claims 1 to 4, further comprising:
a first securing member 361a supported by the external structure 305;
a second securing member 362a provided on the first circuit board 310 and configured to secure the first circuit board 310 to the first securing member 361a;
a third securing member 363a supported by the external structure 305 and penetrating the first circuit board 310; and
a fourth securing member 364a provided on the pressurizing structure 350 and securing the pressurizing structure 350 to the third securing member 363a.

6. The PCB assembly 300 of any of claims 1 to 5, further comprising:
a first securing member 361b supported by the external structure 305;
a second securing member 362b provided on the first circuit board 310 and securing the first circuit board 310 to the first securing member 361b;
a third securing member 363b provided on the first circuit board 310 and supported by the first circuit board 310; and
a fourth securing member 364b provided on the pressurizing structure 350 and securing the pressurizing structure 350 to the third securing member 363b.

7. The PCB assembly 300 of any of claims 1 to 6, further comprising:
a first securing member 361c supported by the external structure 305;
a second securing member 362c provided on the first circuit board 310 and securing the first circuit board 310 to the first securing member 361c;
a third securing member 363c supported by the external structure 305 and penetrating the second circuit board 320; and
a fourth securing member 364c provided on the pressurizing structure 350 and securing the pressurizing structure 350 to the third securing member 363c.

8. The PCB assembly 500 of any of claims 1 to 7, further comprising:
a bracket 535 connected to the thermal module 530 and secured to the first circuit board 510;
a first securing member 561 or 561a provided on the first circuit board 510 and supported by the first circuit board 510; and
a second securing member 562 or 562a provided on the bracket 535 and securing the bracket 535 to the first securing member 561 or 561a,
wherein the pressurizing structure 550 or 550a is provided between the bracket 535 and the second securing member 562 or 562a and is supported by the first circuit board 510 as the first securing member 561 and the second securing member 562 or 562a are secured.

9. The PCB assembly 500 of any of claims 1 to 8, wherein the pressurizing structure 550 or 550a is pressurized by the second securing member 562 or 562a and is configured to apply the pre-load to the thermal module 530 in the direction toward the electronic component 511 by applying the pre-load to the bracket 535 in a direction toward the first circuit board 510.

10. The PCB assembly 500 of any of claims 1 to 9, further comprising:
a shield can 515 provided between the bracket 535 and the first circuit board 510, the shield 515 can at least partially enclosing the electronic component 511,
wherein the first securing member 561 and the second securing member 562 are provided at least partially inside the shield can 515.

11. The PCB assembly 500 of any of claims 1 to 10, further comprising:
a shield can 515 provided between the bracket 535 and the first circuit board 510 , the shield 515 can at least partially enclosing the electronic component 511,
wherein the first securing member 561a and the second securing member 562a are provided at least partially outside of the shield can 515.

12. The PCB assembly 500 of any of claims 1 to 11, wherein the bracket 535 comprises a thermal module hole 536 provided at a position corresponding to the electronic component 511, and
wherein the thermal module 530 is provided in the thermal module hole 536 and contacts the electronic component 511.

13. The PCB assembly 500 of any of claims 1 to 12, further comprising:
a bracket 535 connected to the thermal module 530 and secured to the first circuit board 510;
a first securing member 561b provided on the bracket 535 and supported by the bracket 535; and
a second securing member 562b provided on the first circuit board 510 and securing the first circuit board 510 to the first securing member 561b.

14. The PCB assembly 500 of any of claims 1 to 13, wherein, in the bracket 535 and the thermal module 530, the pressurizing structure 550b is provided on a surface that is opposite to a surface facing the electronic component 511 and applies a pre-load to the thermal module 530 in a direction toward the electronic component 511.

15. The PCB assembly 500 of any of claims 1 to 14, wherein the pressurizing structure 550b is supported by the first circuit board 510 through the first securing member 561b and the second securing member 562b.

16. A printed circuit board (PCB) assembly 300 comprising:
a first circuit board 310;
an electronic component 311 provided on the first circuit board 310;
a second circuit board 320 connected to the first circuit board 310;
a thermal module 330 configured to absorb heat from the electronic component 311; and
a pressurizing structure 350 provided between the thermal module 330 and the electronic component 311 and configured to apply a pre-load to the thermal module 330 in a direction toward the electronic component 311,
wherein the pressurizing structure 350 is separated from the second circuit board 320 and is supported by an external structure 305 by penetrating the first circuit board 310.

17. The PCB assembly 300 of claim 16, further comprising:
a first securing member 361 supported by the external structure 305;
a second securing member 362provided on the first circuit board 310 and securing the first circuit board 310 to the first securing member 361; and
a third securing member 363 penetrating the pressurizing structure 350 and the second securing member 362, the third securing member 363 securing the pressurizing structure 350 to the first securing member 361.

18. The PCB assembly 300 of claim 16 or 17, further comprising:
a first securing member 361b supported by the external structure 305;
a second securing member 362b provided on the first circuit board 310 and securing the first circuit board 310 to the first securing member 361b;
a third securing member 363b provided on the first circuit board 310 and supported by the first circuit board 310; and
a fourth securing member 364b provided on the pressurizing structure 350 and securing the pressurizing structure 350 to the third securing member 363b.

19. A printed circuit board (PCB) assembly 500 comprising:
a first circuit board 510
an electronic component 511 provided on the first circuit board 510;
a second circuit board 520 connected to the first circuit board 510;
a thermal module 530 configured to absorb heat from the electronic component 511;
a bracket 535 connected to the thermal module 530 and secured to the first circuit board 510;
a first securing member 561 or 561a provided on the first circuit board 510 and supported by the first circuit board 510;
a second securing member 562 or 562a provided on the bracket 535 and securing the bracket 535 to the first securing member 561 or 561a; and
a pressurizing structure 550 or 550a provided between the bracket 535 and the second securing member 562 or 562a and configured to apply a pre-load to the thermal module 530 in a direction toward the electronic component 511,
wherein the pressurizing structure is separated from the second circuit board 520 and is supported by the first circuit board 510.

20. The PCB assembly 500 of claim 19, further comprising:
a shield can 515 provided between the bracket 535 and the first circuit board 510 and at least partially enclosing the electronic component 511,
wherein the first securing member 561a and the second securing member 562a are provided outside of the shield can 515.
